# EUROPÄISCHE PATENTSCHRIFT

(11) **EP 1 592 821 B1**
(45) Veröffentlichungstag und Bekanntmachung des Hinweises auf die Patenterteilung: **14.01.2009**
(21) Anmeldenummer: 03812171.1
(22) Anmeldetag: 03.12.2003
(51) Int. Cl.: C23C 14/00, C23C 14/02, C23C 14/58

(54) **VERFAHREN ZUR HERSTELLUNG EINER MULTILAYERSCHICHT UND VORRICHTUNG ZUR DURCHFÜHRUNG DES VERFAHRENS**
METHOD FOR PRODUCING A MULTILAYER COATING AND DEVICE FOR CARRYING OUT SAID METHOD
PROCEDE POUR PRODUIRE UN ENSEMBLE MULTICOUCHES ET DISPOSITIF POUR METTRE EN OEUVRE LEDIT PROCEDE

(30) Priorität: 04.12.2002 DE 10256877; 13.10.2003 DE 10347521
(43) Veröffentlichungstag der Anmeldung: 09.11.2005
(60) Teilanmeldung: 08020218.7
(73) Patentinhaber: Leybold Optics GmbH, 63775 Alzenau (DE)
(72) Erfinder: SCHERER, Michael, 63796 Kahl (DE); PISTNER, Jürgen, 63755 Alzenau-Michelbach (DE); LEHNERT, Walter, 63571 Gelnhausen (DE); HAGEDORN, Harro, 60435 Frankfurt am Main (DE); DEPPISCH, Gerd, 63743 Aschaffenburg (DE); RÖDER, Mario, 63571 Gelnhausen (DE)
(74) Vertreter: Pohlmann, Bernd Michael
(86) Internationale Anmeldenummer: PCT/EP2003/013649
(87) Internationale Veröffentlichungsnummer: WO 2004/050944

(56) Entgegenhaltungen:
- EP-A- 0 719 874
- US-A- 5 820 946
- US-A- 5 849 162
- US-A- 6 127 048
- US-B1- 6 346 176
- US-B1- 6 440 280

## Beschreibung

Die Erfindung betrifft ein Verfahren zur Herstellung dünner Schichten sowie eine Vorrichtung zur Durchführung des Verfahrens.

Zur Herstellung dünner Schichten sind verschiedenste Verfahren aus dem Bereich physikalischer und chemischer Abscheidetechniken bekannt. Abhängig von den gewünschten Eigenschaften der abzuscheidenden Schicht und des gewählten Materialsystems werden unterschiedliche Verfahren eingesetzt.

Insbesondere für Materialien mit hohem Schmelzpunkt ist die Methode der Kathodenzerstäubung (Sputtern) vorteilhaft, bei der in einem Vakuumbereich, der deutlich über einem typischen Restgasdruck für ein Aufdampfverfahren liegt, durch Einwirken eines elektrischen Feldes ein Plasma gezündet wird, aus dem Ionen auf ein auf hohem elektrischen Kathodenpotential liegendes Target beschleunigt werden und diese Ionen Atome aus dem Target heraus schlagen, welche sich sodann auf den Wänden der Vakuumkammer und auf einem zum Target beabstandeten, üblicherweise auf Masse oder einer geringen Biasspannung liegenden Substrat niederschlagen. Ein Erhitzen der Materialquelle ist dabei nicht notwendig, vielmehr wird das Target beim Prozess gekühlt. Dabei resultiert ein Restgasdruck üblicherweise überwiegend aus einem Inertgas wie etwa Argon, welches keine störenden Einflüsse auf die sich auf dem Substrat bildende Schicht zeigt. Zur Abscheidung von Verbindungen wie Nitride, Carbide oder Oxide oder dergleichen können dem Sputtergas zusätzlich entsprechende Reaktivkgase beigemischt werden.

Das Substrat wird üblicherweise ausserhalb der Plasmazone angeordnet, um eine Schädigung der frisch aufwachsenden Schicht durch Bestrahlung aus dem Plasma oder Rücksputtereffekte zu vermeiden. Die mittlere freie Weglänge der Ionen muss gross genug sein, um mit ausreichender kinetischer Energie, d.h. mit möglichst wenig Störungen durch weitere Stossprozesse im Restgas, auf das Target zu gelangen und andererseits die zerstäubten Atome auf das Substrat gelangen zu lassen, was den möglichen Restgasdruck nach oben begrenzt. Andererseits muss der Druck hoch genug sein, um überhaupt ein stabiles Plasma zünden zu können. Durch magnetfeldunterstützes Kathodenzerstäuben gelingt es, am Target eine erhöhte Elektronendichte zu erzeugen, die in einer hohen Plasmadichte am Target und daher in einer stark erhöhten Zerstäubungsrate resultiert.

Durch Zufügen reaktiver Komponenten, insbesondere Sauerstoff, zum Inertgas können auch Oxide hergestellt werden. Ein solches reaktives Zerstäubungsverfahren ist z.B. aus der WO 01/73151 A1 bekannt. Dort wird der Sauerstoffpartialdruck beim Sputtern des Oxids mittels einer Lambda-Sonde geregelt, damit sich in der aufwachsenden Schicht ein stöchiometrisches Oxid bilden kann. Allerdings reagiert auch das Target mit dem Reaktivgas, so dass konkurrierende Verfahren, nämlich Abtrag einerseits und eine die Abtragung hemmende Oxidbildung an der Targetoberfläche ablaufen. Dies hat wiederum Rückwirkungen auf die elektrischen Potentiale in der Beschichtungskammer, die Plasmabildung und dergleichen. Ebenso bilden die sich auf den inneren Oberflächen der Vakuumkammer abscheidenden Schichten des zerstäubten Materials Getterflächen, welche z.B. Sauerstoff als Reaktivkomponente binden und so zu einer gegenseitigen, schwer vorhersagbaren Abhängigkeit verschiedenster Verfahrensparameter führt. Auch hier ist also der Zusammenhang zwischen den Beschichtungsparametern sehr komplex. Häufig kommt es dabei zu gegenseitiger Beeinflussung, wenn ein einzelner Beschichtungsparameter verändert wird. Je nach abzuscheidendem Schichtmaterial ist es daher notwendig, die Beschichtungsverfahren und die Beschichtungsparameter individuell aufeinander abzustimmen. Dies gilt umso mehr, je komplexer ein abzuscheidendes Schichtsystem ist, etwa bei der Abscheidung von Multischichten mit speziellen Funktionseigenschaften, insbesondere optischen Funktionsschichten. Die erwähnten Probleme sind besonders stark ausgeprägt bei dem sogenannten reaktiven DC-Magnetron-Sputtering von metallischen Verbindungen, bei dem die Forderung nach einer reaktiven Verbindung auf der Substratoberfläche bei gleichzeitiger metallischer Targetoberfläche nur mit hohem Aufwand erreichbar ist. Zur Herstellung von isolierenden Schichten, wie z.B. SiO₂, Al₂O₃ und dergleichen sind daher bereits auch Verfahren entwickelt worden, bei denen mittels jeweils zwei Magnetron-Sputterkathoden, die von einer Wechselstromquelle gespeist werden, zwei Targets alternierend eingesetzt werden. Die Polaritäten der Targetpotentiale ändern sich üblicherweise im KHz Bereich, d.h. jede Elektrode ist abwechselnd Kathode und Anode. Dies führt zu einem definierten Ladungstransport zwischen Kathode und Anode ohne hemmenden Einfluss einer Oxidschicht an den Targetoberflächen, im Gegensatz zum störenden Effekt der sogenannten "disappearing anode" beim reaktiven DC-Magnetron-Sputtering.

Ein effizienter Betrieb setzt dabei jedoch voraus, dass in dem sogenannten Übergangsbereich gearbeitet wird, da ansonsten die Oxidbildung an der Targetoberfläche schneller als die Abtragrate ist.

Aus der EP 0 795 623 A1 ist eine Vorrichtung zum Aufbringen dünner Titanoxidschichten mittels reaktiver Kathodenzerstäubung bekannt. Dabei wird die Stromversorgung der Kathode durch ein Signal eines λ-Sonden-Messfühlers, der den Anteil von Sauerstoff in der Vakuumkammer mit einem Referenzgas vergleicht, geregelt. Das Verfahren eignet sich besonders zur langzeitstabilen Abscheidung von Oxiden, die möglichst homogen und mit gleichbleibender Zusammensetzung hergestellt werden sollen.

Aus der DE 42 36 264 C1 ist ein plasmagestütztes Elektronenstrahlbedampfen bekannt, bei dem ein Oxid mit sehr hoher Rate mittels eines Elektronenstrahlverdampfers verdampft und auf einem Substrat abgeschieden wird. Beim Verdampfen dissoziiert jedoch das Oxid, so dass Sauerstoff verloren geht und nicht mehr zur Oxidbildung in der aufwachsenden Schicht zur Verfügung steht. Zwischen Substrat und Verdampfungsquelle befindet sich daher ein Plasmaraum mit einem Sauerstoffplasma, in dem der Dampf auf dem Weg zum Substrat angeregt wird, so dass sich auf dem Substrat ein stöchiometrisches Oxid niederschlagen kann. Je nach Materialsystem gelingt die Abscheidung eines stöchiometrischen Oxids, indem entweder der Partialdruck des Reaktivgases oder die Plasmaparameter während der Beschichtung geregelt werden. Dabei sind die Zusammenhänge sehr komplex und von einem Materialsystem auf ein anderes kaum übertragbar. Eine Variation einzelner Verfahrensparameter führt bei verschiedenen Materialsystemen zu unterschiedlichen Ergebnissen. Optimierte Abscheideparameter für z.B. Aluminiumoxid führen nicht zu optimalen Ergebnissen z.B. bei Siliziumoxid. Darüber hinaus zeigen sich auch innerhalb ein- und desselben Materialsystems Langzeitdriften verschiedener nicht getrennt erfassbarer Verdampfungsparameter, die zu unerwünschten Änderungen der Eigenschaften der abgeschiedenen Schichten führen und die Reproduzierbarkeit eines eingefahrenen Beschichtungsprozesses zusätzlich erschweren.

Aus der EP 0 1516 436 E1 ist eine Magnetron-Sputtervorrichtung zur reaktiven Abscheidung eines Materials auf ein Substrat bekannt mit einer Magnetron-Sputtereinrichtung und einer sekundären Plasmaeinrichtung. Die Sputtereinrichtung und die sekundäre Plasmaeinrichtung bilden jeweils Sputter- und Aktivierungszonen, die atmosphärisch und physikalisch benachbart sind. Durch das Zusammenbringen der Sputter- und Aktivierungszone werden die Plasmen beider Zonen zu einem einzigen kontinuierlichen Plasma vermischt.

Aus der EP 0 716 160 B1 ist eine Beschichtungsvorrichtung bekannt mit einer Abscheidungsvorrichtung und einer Vorrichtung zum Erzeugen eines Plasmas von Ionenniedriger Energie. Die Abscheidungs- und Plasmavorrichtungen können selektiv betrieben werden, so dass eine Kompositschicht gebildet wird, die mindestens mehrere Schichten aufweist. Die Zusammensetzung einer jeden Schicht kann aus mindestens einer der folgenden Substanzen ausgewählt sein: ein erstes Metall, ein zweites Metall, ein Oxid des ersten Metalls, ein Oxid des zweiten Metalls, Mischungen des ersten und zweiten Metalls und Oxide von Mischungen des ersten und zweiten Metalls.

US-B1-6 440 280 gibt ein Verfahren und eine Vorrichtung zur Beschichtung von Linsen, z.B. aus Kunststoff, an. Die Vorrichtung besitzt eine Vakuumkammer, eine Magnetronsputtereinheit, Plasmaquellen und eine Trommel, die die Substrate von der Sputtereinheit zu den Plasmaquellen führt und von dort wieder zur Sputtereinheit transportiert. Außerdem können optische Monitoreinrichtungen zur Messung der abgeschiedenen Schichtdicke vorhanden sein.

US-B1-6 346 176 beschreibt ein Verfahren zum Abscheiden von oxidierten Metallfilmen an, bei dem zuerst eine Schicht eines teilweise oxidierten Metalls in einer Atmosphäre aus einem inerten Gas und einem reaktiven Gas gesputtert wird, und diese Schicht anschließend in eine Oxidationseinrichtung gebracht wird, wo die Schicht mit reaktiven Ionen behandelt wird. In bevorzugter Weise wird ein sauerstoffdefizitärer Metalloxidfilm durch Sputtern abgeschieden, der nachfolgend in einem sauerstoffhaltigen Plasma oxidiert wird.

US-A-6 127 048 offenbart einen Prozeß zur Herstellung von oxidischen Beschichtungen auf einem metallischen Substrat. Der Prozeß kann drei Stufen umfassen bei denen jeweils zwei Metalloxidschichten reaktiv abgeschieden werden und anschließend eine Nachbehandlung in einer Sauerstoffatmosphäre durchgeführt wird.

Aufgabe der Erfindung ist es, ein Verfahren und eine Vorrichtung zur Herstellung einer optisch verlustarmen Multilayerschicht zu schaffen sowie ein Verfahren zur Herstellung eines Breitbandfilters anzugeben.

Die Aufgabe wird mit jeweils den Merkmalen der unabhängigen Ansprüche gelöst.

Gemäß der Erfindung wird bei einem Verfahren zur Herstellung einer Multilayerschicht mit zumindest einer reaktiv betreibbaren Beschichtungseinrichtung und zumindest einer Reaktionseinrichtung in einer Vakuumkammer auf zumindest einem relativ zu den besagten Einrichtungen bewegbaren Substrat auf einer ersten Schicht mittels der Beschichtungsstation eine Abscheidung einer zweiten Schicht mit mindestens einer Reaktivkomponente vorgenommen. Mittels der Reaktionseinrichtung erfolgt eine Änderung der Struktur und/oder Stöchiometrie der Schichten. Zur Verringerung eines optischen Verlustes der Multilayerschicht unter einen vorgegebenen Wert ist es erfindungsgemäß vorgesehen, in einem an die erste Schicht angrenzenden Bereich der zweiten Schicht mittels der Beschichtungseinrichtung ein Interface aufzubauen mit einer Dicke dₗ und einem Wert eines Defizits der Reaktivkomponente DEF kleiner als ein Wert DEFₗ. Dieses Verfahren ermöglicht die Änderung der Struktur und/oder Stöchiometrie der Schichten umfassend zu kontrollieren und vorzugsweise Multilayerschichten mit geringen optischen Verlusten bzw. einer geringen optischen Reflektion und hohen Transmissionen herzustellen.

Das erfindungsgemäße Verfahren zur Herstellung von Multilayern mit minimalen optischen Verlusten geht von der Erkenntnis aus, dass die abgeschiedenen Schichten möglichst eine vollständige Stöchiometrie zwischen einem ersten Konstituenten und einer reaktiven Konstituenten aufweisen sollte. Erfindungsgemäß wird dabei der reaktive Sputterprozess in einem Modus kontrollierter Substöchiometrie betrieben und in einem zweiten Schritt der fehlende Anteil des reaktiven Konstituenten durch die Wirkung der zusätzlichen Plasmaquelle zur Verfügung gestellt. Beispielsweise ist die Sequenz zur Herstellung von stöchiometischen SiO₂-Schichten wie folgt: In einem ersten Schritt erfolgt eine Sputterbeschichtung unter Verwendung eines metallischen Siliziumtargets, wobei ein Reaktivgasfluss von Sauerstoff eingesetzt wird und zu einer substöchiometrischen Verbindung einer Schicht von beispielsweise SiO_{1.6} führt. Der zugehörige Wert des Defizits der Reaktivkomponente DEF ist dann 0.4. In einem zweiten Schritt erfolgt eine Plasmaaktivierung mit Sauerstoff als Reaktivgas, was zu einer vollständig stöchiometrischen SiO₂-Schicht führt.

Die Abscheidung derartiger Schichten wird durch Parameter bestimmt, die materialabhängig sind. Hierbei ist es erfindungsgemäß stets möglich, einen optimalen Kompromiss zwischen einer hohen Sputterrate und einer maximal erreichbaren Stöchiometrie im ersten Schritt kombiniert mit einer maximal effektiven anschließenden Behandlung durch die Plasmaquelle im zweiten Schritt zu gewährleisten.

Erfindungsgemäß werden bei der Herstellung von Multilayerschichten mit einer hochbrechenden Schicht und einer angrenzenden niedrigbrechenden Schicht, beispielsweise zwischen Nb₂O₅ und SiO₂, weitere Maßnahmen ergriffen, um optische Verluste zu vermindern. Diese Maßnahmen sind vorzugsweise angezeigt, da aufgrund der extrem hohen Reaktivität von Silizium eine substöchiometrische Verbindung wie beispielsweise SiO_{1.6}, die auf einer vollstöchiometrischen Nb₂O₅-Schicht aufgesputtert ist, Sauerstoff aus der Nb₂O₅-Schicht entfernt wird, bevor die SiO_{1.6}-Schicht durch die Plasmaquelle in einen vollstöchiometrischen Zustand verändert worden ist. Dies führt zu einer Verschlechterung der optischen Eigenschaften von zumindest einigen Schichten des hochbrechenden Materials und damit zu einer Verschlechterung der Multilayerschicht, insbesondere proportional zur Anzahl der involvierten Interfaces. Erfindungsgemäß wird vorzugsweise, um den beschriebenen Effekt zu verhindern, in beispielsweise einem Bereich des Interfaces, der unmittelbar an das hochbrechende Material angrenzt, eine niedrigbrechende Schicht mit einer gewissen Dicke aufgebracht, die sich in einem weitgehend oder vollstöchiometrischen Zustand befindet. Beispielsweise kann diese Schicht typischerweise eine Dicke von 3.6 nm im Fall von SiO₂ aufweisen. Dieser Bereich des Interfaces wirkt als Barriere für den Schutz der darunter liegenden hochbrechenden Schicht. Sobald eine kritische Dicke des besagten Bereichs erreicht worden ist, können die Parameter des Sputterprozesses verändert werden in Richtung auf die Abscheidung von Schichten mit einem höheren Grad an Substöchiometrie bzw. einem höheren Wert des Defizits DEF der Reaktivkomponente. Es besitzt demnach eine nach dem erfindungsgemäßen Verfahren hergestellte SiO₂-Schicht eine interne Struktur, wobei ein erster Teil ein geringes Defizit an Sauerstoff und ein zweiter Teil einen höheren Wert des Defizits aufweist.

Bevorzugt ist die Herstellung von Multilayerschichten mit alternierend aufeinander folgenden Schichten aus einem hochbrechenden und einem niederbrechenden Material. Bevorzugt ist als hochbrechendes Material Nb₂O₅, Ta₂O₅, TiO₂, ZrO₂ oder Al₂O₃ und als niederbrechendes Material SiO₂ vorgesehen.

Gegenüber dem aus dem Stand der Technik bekannten Aufoxidieren metallischer Schichten oder Halbleiterschichten, erlaubt insbesondere die gezielte Abscheidung einer substöchiometrischen Schicht gemäß Anspruch 9 im Bereich einer Sputtereinrichtung eine Steigerung der Beschichtungsrate, da die nachfolgende Plasmaeinwirkung dickere Schichten in kürzerer Zeit zum stöchiometrischen Oxid oxidieren kann. Ferner erlaubt die reaktive Abscheidung einer Schicht mit einer vorgegebenen Schichtdicke gemäß Anspruch 10 mit einem optischen Verlust, der einen vorgegebenen Mindestwert unterschreitet, und nachfolgender Plasmaeinwirkung eine relativ schnelle Herstellung von Schichten mit geringen optischen Verlusten. Im Vergleich zu bekannten reaktiven Sputterprozessen kommt der Sputterprozeß weniger durch Störungen wie Überschläge oder Kathoden-Arcing zum Erliegen während gleichzeitig Schichten hoher Qualität gebildet werden.

Mit dem erfindungsgemäßen Verfahren gelingt die Abscheidung dünner Schichten mit hoher Präzision und ausgezeichneter Güte. In einer besonders bevorzugten Ausführungsform gelingt die Herstellung oxidischer, carbidischer und nitridischer Schichten mit hoher optischer Güte.

Weitere Ausgestaltungen und Vorteile der Erfindung sind den weiteren Ansprüchen sowie der Beschreibung zu entnehmen.

Die Erfindung wird anhand von Zeichnungen näher beschrieben, wobei die Figuren in schematischer Darstellung zeigen:
- Fig. 1: Eine Prinzipdarstellung einer bevorzugten Anordnung von Substrat, Target und Plasmaquelle zur Oxidation einer Schicht.
- Fig. 2 bis Fig. 5: Kennlinien bei einer reaktiven Kathodenzerstäubung.
- Fig. 6: Ein Beispiel der optischen Transmission einer Schicht als Funktion der Wellenlänge mit und ohne rf-Plasmaquelle als Parameter der Kurvenschar.
- Fig. 7: Ein Beispiel der optischen Transmission einer Schicht als Funktion der Wellenlänge mit der Substratgeschwindigkeit als Parameter der Kurvenschar.
- Fig. 8: Zeigt Beispiele für optische Verluste von Einzelschichten mit unterschiedlichen Schichtdicken.
- Fig. 9: Die Struktur einer Multilayerschicht mit Interface.
- Fig. 10: Den Einfluss der Anzahl von Interfaces bei einer Multilayerschicht auf Transmission und Reflektion.
- Fig. 11: Den Effekt einer Minimierung des optischen Verlustes für eine Multilayerschicht nach dem erfindungsgemäßen Verfahren.
- Fig. 12: Optische Verluste für Einzel- und Multilayerschichten aus hoch- und niederbrechendem Material und für verschiedene Schichtdicken; die mit A und B bezeichneten Kurven entsprechen Multilayern mit 77 bzw. 21 Interfaces ohne Interfaceoptimierung; die mit C, D, E, F bezeichneten Kurven entsprechen Einzelschichten; eine Multilayerschicht und 77 Interfaces und Interfaceoptimierung ist mit XY bezeichnet.
- Fig. 13: Transmission und Reflektion für eine Multilayerschicht mit geringen optischen Verlusten, beispielsweise für Breitbandfilter.
- Fig. 14: Optische Verluste für eine Multilayerschicht für verschiedene Dicken eines Interfaces. A entspricht einer Dicke von 2,7nm, B einer Dicke von 3,6nm.
- Fig. 15: Kennlinien bei einer reaktiven Kathodenzerstäubung von Silizium mit Leistungen von 1 KW und 1,5KW.
- Fig. 16: Werteverläufe verschiedener Verfahrensparameter bei einer reaktiven Kathodenzerstäubung von Silizium.

Mit dem erfindungsgemäßen Verfahren können durch reaktives Sputtern ohne das Vakuum zu brechen Schichten mit geringen optischen Verlusten hergestellt werden, welche Reaktionskomponenten wie Sauerstoff, Kohlenstoff oder Stickstoff enthalten. Im Folgenden wird eine Oxidherstellung beschrieben; das Verfahren ist jedoch auch für Carbide oder Nitride oder Mischungen wie Oxinitride oder Carbonitride oder dergleichen geeignet, wobei auch 2 oder mehr reaktive Gase (Reaktivgase) als Reaktivkomponente gleichzeitig benutzt werden können.

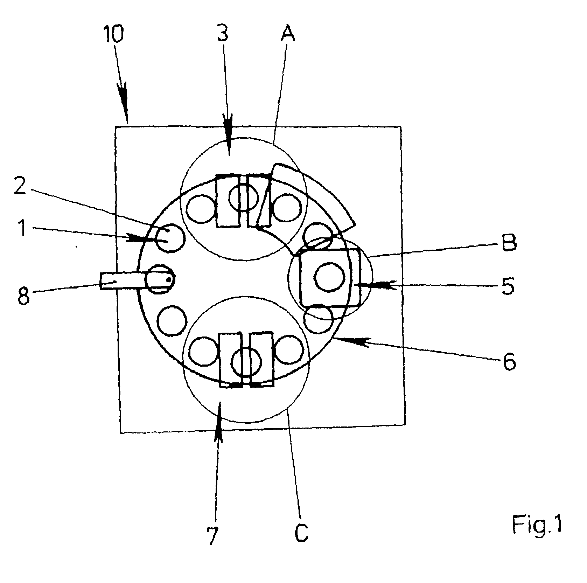

Fig. 1 zeigt eine schematische Skizze einer bevorzugten Anordnung zur Abscheidung einer Schicht gemäß einer Ausführungsform der Erfindung. Eine Oxidschicht 1 wird in einer Vakuumkammer 10 mit einem Restgas auf einem Substrat 2 abgeschieden. Die Vakuumkammer 10 ist in mehrere Bereiche A, B, C eingeteilt. Vorzugsweise hat jeder Bereich A, B, C eine eigene, nicht dargestellte Gaszuführung, sowie eine eigene Pumpenversorgung. Vorzugsweise ist das Vakuum kohlenwasserstofffrei und wird mit einem trockenlaufenden Pumpensatz erzeugt. Es können auch mehr als drei solcher Bereiche vorgesehen sein. Die Bereiche A, B, C sind vorzugsweise voneinander mit Blenden abgeteilt, die nur durch Schlitze miteinander verbunden sind. Damit wird eine vakuummäßige Trennung von im Folgenden noch näher beschriebenen Prozessstationen, nämlich Sputtereinrichtungen bzw. eine Plasmaquelle, in den Bereichen A, B, C erreicht. Vorzugsweise sind die Prozessstationen plasmamässig entkoppelt. Die Drücke, vorzugsweise die Partialdrücke von Gasen im Restgas (Sputtergas) der Anlage können im wesentlichen unabhängig voneinander eingestellt werden. Vorzugsweise ist ein Inertgas wie Argon Ar und ein Reaktivgas, vorzugsweise Sauerstoff O₂ im Restgas enthalten.

Im Bereich A ist als Sputtereinrichtung 3 eine erste Kathodenzerstäubungsquelle vorgesehen, vorzugsweise eine Magnetronquelle, besonders bevorzugt ein an sich bekanntes Magnetronquellensystem mit zwei nebeneinander liegenden Magnetronanordnungen, auch als Twinmag bekannt. Die Stromversorgung kann eine Versorgungseinheit mit DC-, DC-Puls- oder Mittelfrequenz- (MF) oder Hochfrequenz- (HF) oder eine kombinierte DC-HF-Versorgung sein. Typische Spannungsbereiche der Sputterkathode sind 400V bis 800V. Vorzugsweise wird eine MF-Quelle mit 40 kHz eingesetzt.

In dem Bereich A wird mittels reaktivem Sputtern ein Sputtermaterial eines Targets zerstäubt, wobei sich jeweils mit einer arbeitspunktabhängigen Sputterrate ein Sputtermaterial-Sauerstoff-Verbund an Wänden der Vakuumkammer 1 und auf den Substraten 2 niederschlägt. Bevorzugte Sputtermaterialien sind Metalle und Metalllegierungen wie Al, Nb, Hf, Ta, Ti, Zr, TiNb sowie Halbleiter wie Si.

Im Bereich B ist eine Plasmaquelle 5 angeordnet, die ein Plasma erzeugt, welches angeregte lonen und Radikale des reaktiven Bestandteils des Restgases enthält. Die reaktiven Teilchen wirken auf die abgeschiedene Schicht ein und oxidieren diese weiter. Die Plasmaquelle 5 kann beispielsweise eine DC-, HF- MF- oder DC-Puls- oder DC+HF-Mikrowellen-Plasmaquelleneinrichtung, insbesondere eine Hall End Plasmaquelle, eine Heisskathoden DC-Plasmaquelle, eine Hochfrequenz-Plasmaquelle, eine Mittelfrequenz- oder eine gepulste DC-Plasmaquelle sein. Die Energie der Plasmaquelle 5 ist einstellbar, vorzugsweise auf einen Bereich 10 eV bis 200 eV oder auch 400eV. Vorzugsweise wird eine ECWR-Plasmaquelle (Electron-Cyclotron-Wave-Resonance) eingesetzt, bei der die Energie der Plasmateilchen weitgehend unabhängig von der Plasmadichte in der Plasmaquelle 5 eingestellt werden kann.

In einem Bereich A der Vakuumkammer 10, vorzugsweise zwischen den beiden Bereichen A und B, kann eine Heizvorrichtung angeordnet sein, vorzugsweise eine Strahlungsheizung mit Quarzstrahlern. Alternativ können auch Infrarot-Strahler vorgesehen sein. Damit können die Substrate auf mehrere hundert Grad erhitzt werden, beispielsweise auf 250°C.

Ferner ist ein Bereich C vorgesehen, in dem eine zweite Kathodenzerstäubungsquelle 7 diametral gegenüberliegend angeordnet ist, welche vorzugsweise wie die erste Kathodenzerstäubungsquelle 3 ausgebildet ist. In einer weiteren Ausführungsform sind weitere Sputtereinrichtungen und/oder Plasmaquellen in der Vakuumkammer vorgesehen. Räumlich zwischen den Bereichen A und C ist eine optische Messeinrichtung (optischer Monitor) 8 zum optischen Monitoring angeordnet, mittels der optische Eigenschaften der aufwachsenden Schichten bestimmt werden können. Bevorzugt werden, wie an sich bekannt, Transmission und/oder Reflexion einer Schicht intermittierend auf mindestens einem der Substrate zur Ermittlung von optischen Eigenschaften der aufgebrachten Schicht gemessen. Damit kann insbesondere auch die aufwachsende optische Schichtdicke überprüft werden.

Eine vorzugsweise planare Transporteinrichtung 6 bewegt ein Substrat 2 mindestens einmal nacheinander an mindestens einer Kathodenzerstäubungsquelle 3, 7 und an mindestens einer Station mit einer Plasmaquelle 5 vorbei. Dabei ist die Transporteinrichtung 6 vorzugsweise ein Substrat-Drehteller mit einer einstellbaren Geschwindigkeit von beispielsweise 1 bis 500 rpm. Die Beschleunigung auf hohe Solldrehzahlen kann in wenigen Stufen und jeweils innerhalb desselben Bereichs A, B, C erfolgen. Anstelle einer planaren Transporteinrichtung kann auch eine an sich bekannte trommelförmige Einrichtung zur Halterung und zum Transport der Substrate eingesetzt werden. In diesem Fall sind Sputtereinrichtung und Plasmaquelle einem peripheren Oberflächenbereich der Trommel zugeordnet.

Üblicherweise werden ein oder mehrere Substrate 2 auf dem Drehteller 6 befestigt. Der Übersichtlichkeit wegen ist nur eines der in der Figur 1 als Kreis gezeigten Substrate mit einem Bezugszeichen bezeichnet.

In der Vakuumkammer 10 wird das Substrat 2 von dem Drehteller 6 unter die erste Kathodenzerstäubungsquelle 3 bewegt. Dort wird durch Kathodenzerstäubung das Target zerstäubt, wobei sich aus dem Target herausgeschlagenes Material auf dem Substrat niederschlägt. Als Sputtergas wird in einer bevorzugten Ausführungsform der Erfindung ein Argon-Sauerstoffgemisch verwendet, so dass die auf dem Substrat 2 aufwachsende Schicht 1 ein Oxid ist.

Der Kathodenzerstäubungsprozes wird so betrieben, dass in dem Bereich A bzw. C unter Zuführung einer Reaktivkomponente gezielt eine Verbindungsschicht mit vorgegebener Zusammensetzung abgeschieden wird. Die Schicht 1 wird mit zumindest zwei Konstituenten gebildet, wobei der reaktive Bestandteil O₂ einen der Konstituenten bildet und, bezogen auf den Bestandteil O₂, die Schicht 1 substöchiometrisch hergestellt. Bezogen auf eine stöchiometrische Verbindung der Konstituenten wird die Schicht 1 mit einem vorgegebenen Defizit, beispielsweise von höchstens 90, 80, 70, 60, 50, 40, 30, 20 oder weniger Atomprozent des reaktiven Bestandteils O₂ abgeschieden. Anschließend wird in dem Bereich B der Gehalt des Bestandteils O₂ in situ mittels einer Plasmaeinwirkung auf die Schicht 1 in der Schicht 1 bis zur stöchiometrischen Zusammensetzung erhöht und/oder die Struktur der Schicht modifiziert. Statt des reaktiven Bestandteils O₂ kann im Bereich B auch ein anderes reaktives Gas zugeführt werden.

Besonders günstig ist es, wenn der Partialdruck des Bestandteils O₂ in dem Bereich der Kathodenzerstäubungsquelle 3 während der Beschichtung des Substrats 2 auf einen im Wesentlichen konstanten Wert geregelt wird. Günstigerweise wird der Partialdruck des Bestandteils O₂ über dessen Gasfluss eingestellt. Es ist auch möglich, den Sauerstoffpartialdruck über die elektrische Leistung der Kathodenzerstäubungsquelle 3 konstant einzustellen, wobei die Rate über die Targetlebensdauer in besonders hohem Masse konstant gehalten werden kann.

Weiterhin kann in dem Bereich A der Kathodenzerstäubungsquelle 3 während der Beschichtung des Substrats 2 eine Intensität einer Plasmaemissionslinie, vorzugsweise einer Emissionslinie für das Targetmaterial, des reaktiven Bestandteils oder eine Kombination beider auf einen wesentlichen Konstantwert geregelt werden. Dieses kann über den Gasfluss des Bestandteils O₂ und/oder die elektrische Leistung der Kathodenzerstäubungsquelle 3 eingestellt werden.

Die Schichteigenschaften können auch variiert werden, indem die Geschwindigkeit, mit der das Substrat 2 an der Plasmaquelle 5 und/oder der Kathodenzerstäubungsquelle 3 vorbei geführt wird, verändert wird.

Eine Schicht kann auch über mehrere Zwischenschritte durch unterstöchiometrische Abscheidung/Oxidation hergestellt werden. Weiterhin können Mehrfachschichten abgeschieden werden, bei denen durch Variation der Schichtparameter in Einzellagen wechselnde Brechungsindizes entlang einer aufwachsenden Gesamtschicht erzielt werden. Solche Mehrfachschichten können beispielsweise kontrolliert abgeschieden werden, indem die Beschichtungs- und/oder Oxidationszeit, und/oder die Anzahl der Rotationen eingestellt wird und/oder über die optische Messeinrichtung 8 die Beschichtung anhand der optischen Eigenschaften der aufwachsenden Schicht oder Schichtfolge gesteuert wird.

Gemäß einer anderen Ausführungsform wird in dem Bereich A der Kathodenzerstäubungsquelle 3 unter Hinzufügung einer vorgegebenen Menge der Reaktivkomponente auf dem Substrat eine Schicht mit einer vorgegebenen Schichtdicke abgeschieden, die optische Verluste geringer als ein vorgegebener Mindestwert aufweist. Als optischer Verlust wird dabei in an sich bekannter Weise die im Allgemeinen wellenlängenabhängige Dämpfung einer auf eine Schicht einfallenden Lichtwelle bezeichnet. Die optischen Verluste können aus Messungen der Transmission und Reflektion ermittelt werden. Da das Streulicht durch diffuse Streuung in einem Zusammenhang mit der Rauhigkeit einer Oberfläche steht, lassen sich aus den optischen Verlusten einer Schicht auch Rückschlüsse auf die Oberflächenbeschaffenheit ziehen. Bevorzugt werden erfindungsgemäß die optischen Verluste mittels der optischen Messeinrichtung (optischer Monitor) 8 bestimmt. Der optische Monitor 8 ist besonders bevorzugt als ein Einwellenlängen- oder Mehrwellenlängen Spektrometer, insbesondere als Spektralfotometer oder Ellipsometer, besonders bevorzugt Spektralellipsometer ausgebildet. Es werden nach Abscheidung einer vorgegebenen Schichtdicke, die optischen Verluste ermittelt und es folgt eine Einstellung von Schichteigenschaften in Abhängigkeit von einem Signal des optisches Monitors 8. Bei Einsatz eines Spektralfotometers können in einfache Weise Transmission, Absorption und Reflektion in einem vorgegebenen Spektralbereich und als Funktion der Schichtdicke ermittelt werden.

Im Folgenden wird die Prozessführung zur Herstellung einer Schicht durch reaktives Sputtern mit einer anschließenden Modifikation der aufgebrachten Schicht beschrieben. Andere Prozessführungen sind ebenfalls möglich. Als Sputtereinrichtung wird ein Magnetronquellensystem mit zwei nebeneinander liegenden Magnetronanordnungen mit zwei Niob-Targets eingesetzt. Die Targets werden in einem MF - Bereich, beispielsweise mit einer Frequenz von 40 kHz alternierend betrieben. Beiden Targets sind Shutter zugeordnet, mit denen die Sputtereinrichtung gegenüber den Substraten isoliert werden kann. Die Plasmaquelle, welcher ebenfalls ein Shutter zugeordnet ist, wird in einem Radiofrequenzbereich angesteuert.

In einem ersten Schritt wird die Sputtereinrichtung in einen Arbeitspunkt eingestellt, wobei zur Stabilisierung des Prozesses die Shutter geschlossen sind. Es erfolgt ein Einlass von einem Inertgas und einer Reaktivkomponente (beispielsweise Argon und Sauerstoff) in dem Bereich der Sputtereinrichtung. Ferner folgt ein Einlass von einem Inertgas und einer Reaktivkomponente in den Bereich der Plasmaquelle. Der Substratträger, beispielsweise ein planarer Drehteller, wird auf eine Sollgeschwindigkeit beschleunigt. In einem weiteren Schritt wird das Plasma der Plasmaquelle gezündet. Es erfolgt ferner eine Zündung des Sputterplasmas der Kathodenzerstäubungseinrichtung, die auf eine vorgegebene Sollleistung gebracht wird. Anschließend wird eine Partialdruckregelung im Bereich der Sputtereinrichtung aktiviert. Vorzugsweise wird ein vorgegebener Partialdrucksollwert über die Kathodenleistung stabilisiert.

In einem zweiten Schritt wird mit der Beschichtung der Substrate begonnen. Hierzu werden die Shutter geöffnet. Dabei hat sich gezeigt, dass nur eine geringe Änderung der im Arbeitspunkt eingestellten Regelungsparameter durch die Öffnung der Shutter notwendig ist. Eine gewünschte Schichtdicke kann über eine Beschichtungszeit bzw. eine Anzahl von Rotationen kontrolliert werden. Besonders bevorzugt ist eine in situ erfolgende optische Schichtdickenmessung durch den optischen Monitor 8.

Die reaktive Abscheidung einer Schicht erfolgt in einem Arbeitspunkt einer Kennlinie oder eines Kennfeldes, der Sputtermaterial- und reaktivkomponentenmaterial-abhängig zur Minimierung eines optischen Verlustes der abgeschiedenen Schicht oder der durch Plasmaeinwirkung modifizierten Schicht gewählt wird. Im Folgenden werden einige bevorzugte Kennlinien dargestellt.

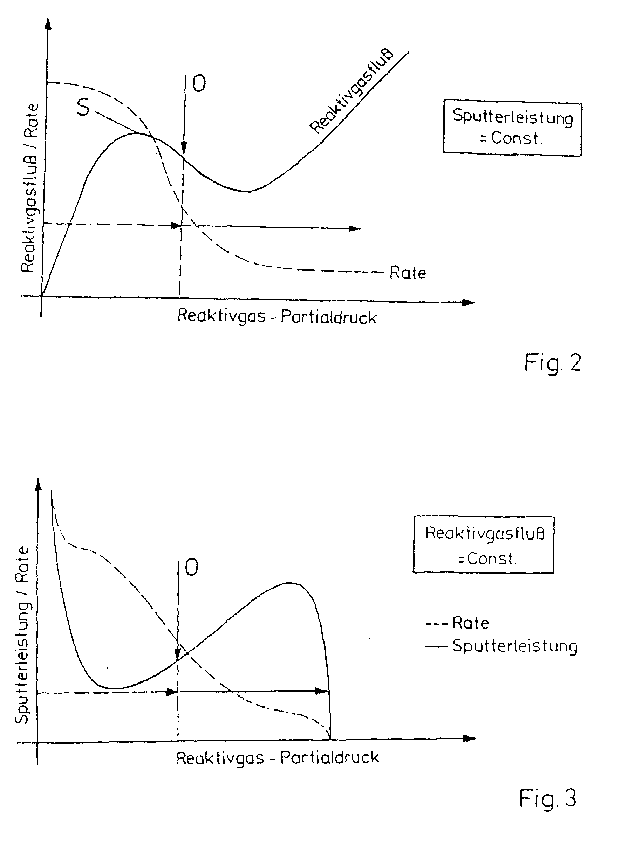

In Fig. 2 ist eine Kennlinie der Abhängigkeit eines Reaktivgasflusses von einem Partialdruck der Reaktivkomponente bei einem Kathodenzerstäubungsprozess in einem Beispiel mit einem Aluminiumtarget und mit Sauerstoff als reaktivem Bestandteil und konstanter Leistung der Sputtereinrichtung (Sputterleistung) angegeben. Bei kleinen Werten des Partialdrucks steigt der Sauerstofffluss zuerst steil an und fällt nach einem Scheitelpunkt S ab, um bei höherem Partialdruck nach einem Minimum wieder anzusteigen. Bei sehr niedrigem Sauerstoffpartialdruck stellt sich ein Zustand mit einer weitgehend metallischen Targetoberfläche ein, wobei metallische Schichten auf dem Substrat deponiert werden. Wird der Sauerstoffpartialdruck über einen Wert, der dem Scheitelpunkt entspricht, erhöht, folgt bei flußgeregeltem Prozess ein Übergang zu einem Oxid- oder Compound-mode, bei der die Targetoberfläche vollständig mit Reaktionsprodukten belegt ist und stöchiometrische Schichten mit ungünstigen Schichteigenschaften auf dem Substrat aufwachsen. Der mit O bezeichnete Pfeil gibt den Übergang zu dem Oxid- oder Compound-mode an. Die gestrichelte Kurve in Figur 2 beschreibt die zugehörige Abscheidungsrate. Es ist ersichtlich, dass diese bei einem niedrigen Reaktivgaspartialdruck maximal ist und bei wachsendem Reaktivgaspartialdruck abfällt, bis sie in einen Sättigungsbereich parallel zur Abszisse kommt. Vom oxidischen her kommend, findet der Übergang in den metallischen Bereich erst bei niedrigerem Sauerstoff-Partialdrücken statt, so dass die Kennlinie eine Hysterese aufweist. Der Bereich zwischen dem Scheitelpunkt und dem Minimum der Kennlinie ist im allgemeinen nicht ohne aufwendige Regelungsmaßnahmen zugänglich, ermöglicht jedoch die Abscheidung von substöchiometrischen Schichten mit einer hohen Abscheidungsrate. Das erfindungsgemäße Verfahren wird vorzugsweise in einem vorgegebenen Bereich der Kennlinie mit ansteigendem oder abfallendem Gasfluss nahe des Scheitelpunktes S durchgeführt, da hier relativ hohe Sputterraten erreicht werden können. Besonders bevorzugt ist der Bereich nahe dem Scheitelpunkt S der Kennlinie, mit einem Gasfluss des ersten Bestandteils O₂ welcher bei der Abscheidung der Schicht 1 höchstens um 50%, unterhalb des Maximalwerts im Scheitelpunkt S, besonders bevorzugt höchstens 20% bis 10% unterhalb des Maximalwerts im Scheitelpunkt S liegt. In diesem Bereich ist eine hohe Abscheidungsrate einer substöchiometischen Schicht erreichbar, die anschließend einer Plasmaeinwirkung ausgesetzt wird. Materialabhängig, z. B. bei Ti, Nb, TiNb kann erfindungsgemäß in dem Übergangsbereich rechts des Scheitelpunktes S gearbeitet werden, während für andere Materialien, z. B. Al, Si der Bereich links des Scheitelpunktes S bevorzugt wird.

In Fig. 3 ist analog eine Kennlinie bei einem konstant gehaltenen Reaktivgasfluss dargestellt, bei der ein Sollwert eines Reaktivgaspartialdrucks mit Hilfe der Sputterleistung eingestellt wird. Der substöchiometrische Bereich liegt hier links des mit O bezeichneten Pfeils. Bei diesem Regelungsverfahren wird erfindungsgemäß bevorzugt, jedoch nicht ausschließlich in einem Bereich um das Minimum der Kennlinie gesputtert.

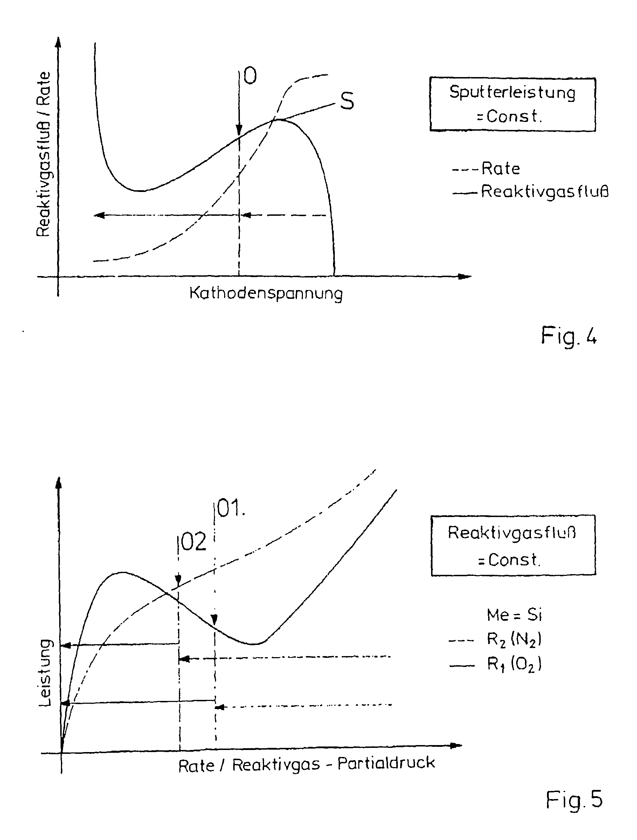

In Fig. 4 ist eine weitere Kennlinie dargestellt, bei der bei konstanter Sputterleistung ein Sollwert einer Sputterkathodenspannung mit Hilfe eines Reaktivgasflusses und in dem Bereich rechts des mit O bezeichneten Übergangs zu einer substöchiometrischen Verbindung eingestellt wird. Bevorzugt ist hier ein Bereich um das Maximum S des Übergangs.

Ein konstanter Reaktivgasfluss wird bei der in Fig. 5 dargestellten Kennlinie verwendet, wobei ein Sollwert eines Quotienten aus einer Sputterrate und einem Reaktivgaspartialdruck mit Hilfe der elektrischen Leistung der Sputtereinrichtung auf einen vorgegebenen Sollwert geregelt wird. Die durchgezogene Kurve bezeichnet hierbei die Kennlinie bei Sauerstoff als Reaktivgas, während die gestrichelte Kurve die Kennlinie bei Stickstoff als Reaktivgas bezeichnet. Die mit 01 bzw. 02 bezeichneten Pfeile geben den Übergang von einem substöchiometrischen rechts des Übergangs zu einem stöchiometrischen Regime links des Übergangs jeweils für Sauerstoff bzw. Stickstoff als Reaktivgas an. Ersichtlich ist, dass die Position dieses Übergangs von dem verwendeten Reaktivgas abhängig ist. Ferner ist das im Fall von Sauerstoff rechts des erwähnten Übergangs bei 01 liegende Minimum in der entsprechenden Kennlinie für Stickstoff verschwunden; dem entspricht ein Fehlen einer Hysterese. Der Quotient aus Sputterrate und Reaktivgaspartialdruck kann aus einem Quotienten aus einer Material- und Reaktivgaspartialdruck-Plasmalinienintensität bestimmt werden. Mit Material ist hierbei das Material der Sputterkathode gemeint; im vorliegenden Fall Silizium. Eine derartige Zweilinienmessung hat den Vorteil, dass das Ergebnis relativ unabhängig von einer Verschmutzung eines Lichtleitereintrittsfensters ist, durch das die entsprechenden Emissionslinien gemessen werden.

Typische Werte für die vorliegende Einrichtung sind für den Argonfluss 40 sccm/min und für den Sauerstofffluss 30 sccm/min im Bereich der Sputtereinrichtung. Bevorzugt wird ein Sauerstoffpartialdruck aus dem Signal einer im Bereich der Sputtereinrichtung angeordneten Lambdasonde bestimmt. Die typische Leistung einer derartigen Dual Magnetronkathoden Station bei dem erfindungsgemäßen Verfahren liegt im Bereich von 4 KW. Im Bereich der Plasmaquelle ist der typische Sauerstofffluss in einem Bereich von 20 sccm/min, während der Argonfluss in einem Bereich von 2 sccm/min liegt. Die Leistung bei einem RF-Betrieb liegt in einem Bereich um 1 KW.

Zur Regelung der Sputtereinrichtung 3, 7 und der Plasmaquelle 5 sowie der Bewegung der Substrate ist eine zeichnerisch nicht dargestellte Steuereinheit vorgesehen. Die Regelung erfolgt in einem Parameterraum, in dem Kennlinien bzw. Kennfelder aufgespannt sind, wie bereits genauer erläutert wurde.

Bevorzugt ist vorgesehen, dass ein Signal des optischen Monitors 8 herangezogen wird, um die Betriebsparameter zur Optimierung der optischen Qualität, insbesondere zur Minimierung der optischen Verluste der abgeschiedenen Schicht einzustellen. Dies erfolgt vorzugsweise online. Ebenso ist eine derartige Regelung schichtweise oder bei einem Übergang von einer Schicht zur nächsten vorgesehen. Besonders bevorzugt ist die Verwendung des optischen Signals für die Durchführung einer Führungsregelung zur Berücksichtigung von Langzeitdriften in den Schichteigenschaften, wie Transmission, Reflektion, und/oder optischer Verluste. Ferner wird die Funktion der die Sputtereinrichtung 3,7 und die Plasmaquelle 5 umfassenden Gesamtvorrichtung in Hinblick auf optische Eigenschaften der abgeschiedenen und modifizierten Schicht oder in Hinblick auf die Geschwindigkeit der Schichtherstellung optimiert. Hierzu werden beispielsweise mittels der Steuereinrichtung entsprechende Arbeitspunkte auf einer Kennlinie bei anschließender Plasmaeinwirkung gewählt und ein Optimierungswert bestimmt.

Optisches Monitoring kann unmittelbar nach jedem Sputtern durch die Sputtereinrichtung 3, 7 und/oder nach einer Plasmaeinwirkung durch die Plasmaquelle 5 auf mindestens einem Substrat erfolgen.

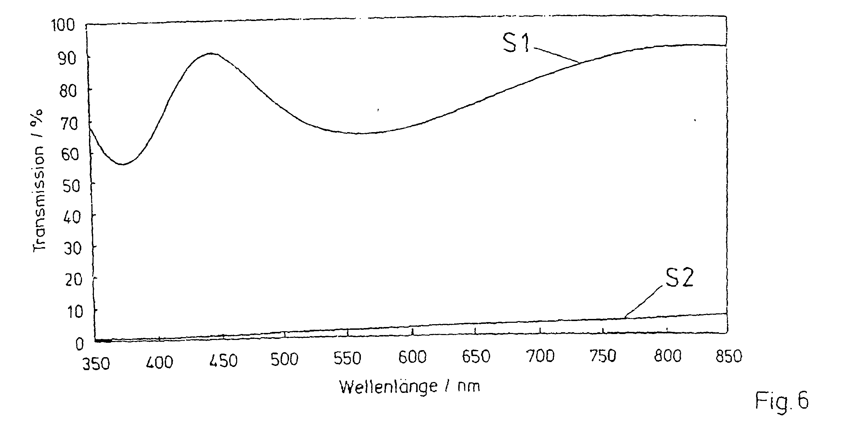

Fig. 6 zeigt ein Beispiel der optischen Transmission einer mit dem Verfahren hergestellten Schicht als Funktion der Wellenlänge (obere Kurve S₁) im Vergleich mit einer Schicht, welche nach der unterstöchiometrischen Abscheidung nicht dem Sauerstoffplasma aus der Plasmaquelle 5 ausgesetzt wurde (untere Kurve S₂). Die Beschichtungsparameter der beiden Schichten sind bis auf die Oxidation im Bereich der Plasmaquelle 5 gleich. Die unterstöchiometrische Schicht zeigt eine sehr geringe Transmission dafür aber sehr hohe Verluste, so dass diese als Antireflexschicht oder Filter oder dergl. unbrauchbar ist. Offenbar ist zu erkennen, dass die Oxidation durch die Plasmaeinwirkung eine sehr effektive Verbesserung der Schichteigenschaften ermöglicht (obere Kurve S₁).

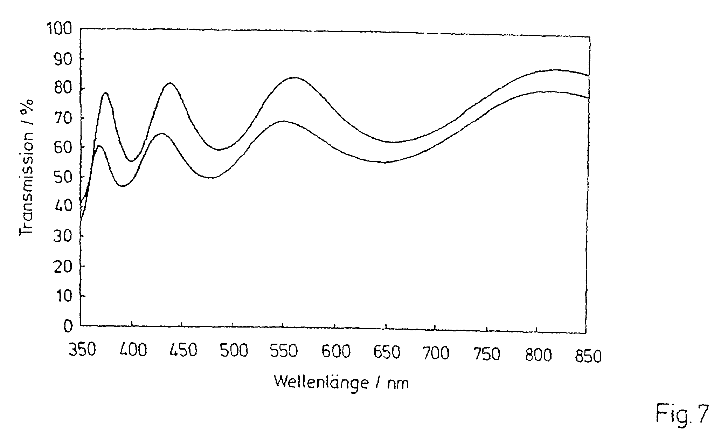

Fig. 7 zeigt ein Beispiel einer optischen Transmission einer Schicht als Funktion der Wellenlänge mit der Substratgeschwindigkeit als Parameter der Kurvenschar. Bei einer hohen Geschwindigkeit von z.B. 180 oder 120 U/min ist die optische Transmission der Schicht höher (obere Kurve) als nur mit halber Geschwindigkeit von z.B. 60 U/min (untere Kurve).

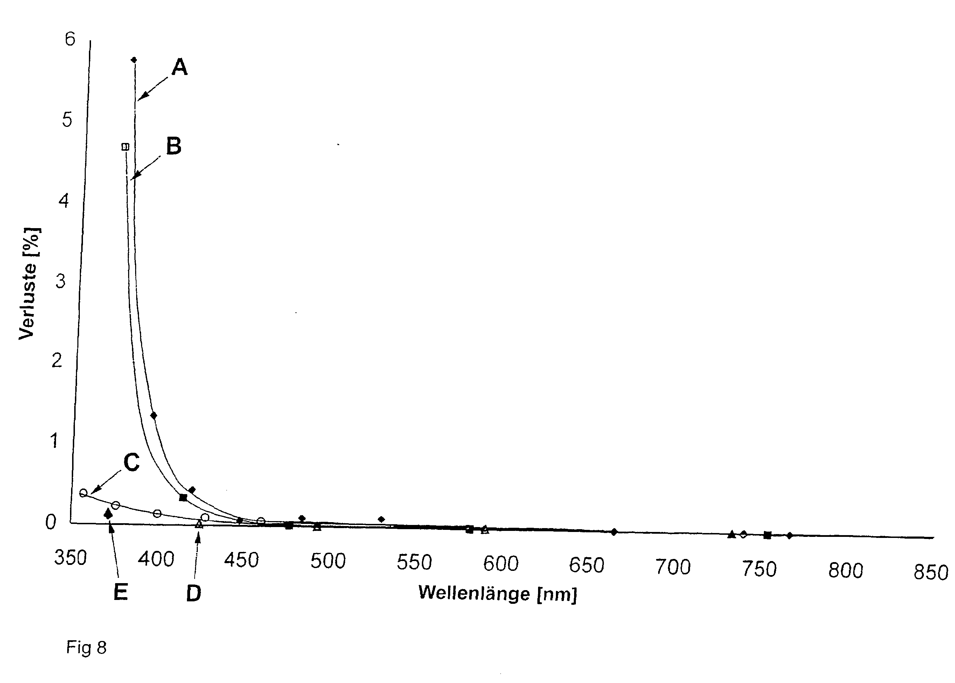

Fig. 8 zeigt Beispiele von Einzelschichten unterschiedlicher Dicke, die gemäß der Erfindung hergestellt wurden. Hierbei bezeichnen die Kurven A und B Nb₂O₅-Schichten mit einer Dicke von 1.000 nm bzw. 500 nm. Die Kurve C bezeichnet eine Ta₂O₅-Einzelschicht mit einer Dicke von 1.000 nm. Die Kurven D und E bezeichnen SiO₂-Schichten mit 1.000 nm bzw. 500 nm Dicke. Erkennbar ist, dass die optischen Verluste von dem verwendeten Material, von der Schichtdicke und der Wellenlänge abhängig sind. Insgesamt sind die optischen Verluste sehr klein und steigen nur im Bereich der Absorptionskante des betreffenden Materials an.

Abgeschiedene Einzelschichten aus einem hochbrechenden Material wie Nb₂O₅, Ta₂O₅, TiO₂, ZrO₂, Al₂O₃ erfordern für einen geringen optischen Verlust eine Abscheidung bei dem reaktiven Sputtern mit nur geringem Sauerstoffdefizit, wobei die Schichten danach dem reaktiven Plasma der Plasmaquelle ausgesetzt werden. Die Energie der Teilchen des reaktiven Plasmas der Plasmaquelle 5 ist dabei bevorzugt kleiner als 50 eV. Für niederbrechende Einzelschichten wie SiO₂ kann ein geringer optischer Verlust auch mit einem größeren Sauerstoffdefizit beim reaktiven Sputtern und nachfolgender Einwirkung des reaktiven Plasmas der Plasmaquelle erreicht werden.

Eine ausgezeichnete optische Qualität der Schichten ergibt sich, wenn diese zunächst substöchiometrisch mit einem definierten Sauerstoffmangel hergestellt und anschließend durch Plasmaeinwirkung zum stöchiometrischen Oxid aufoxidiert werden. Pro Umlauf wird typischerweise 0,2 bis 0,4 nm abgeschieden. Die abgeschiedene Schicht ist vorzugsweise röntgenamorph oder nanokristallin mit einer glatten Oberfläche, weist jedoch gleichzeitig eine dichte Struktur frei von Hohlräumen sogenannten voids auf, so dass eine Vermeidung von Wassereinbau aus der Atmosphäre erreicht wird, was ansonsten zu unerwünschten Brechwertänderungen führen würde. Die verbesserte Oberflächenstruktur ist wesentlich auf die Plasmaeinwirkung zurückzuführen, die insofern eine im Stand der Technik übliche Beaufschlagung des Substrats mit einer Bias - Spannung ersetzen kann.

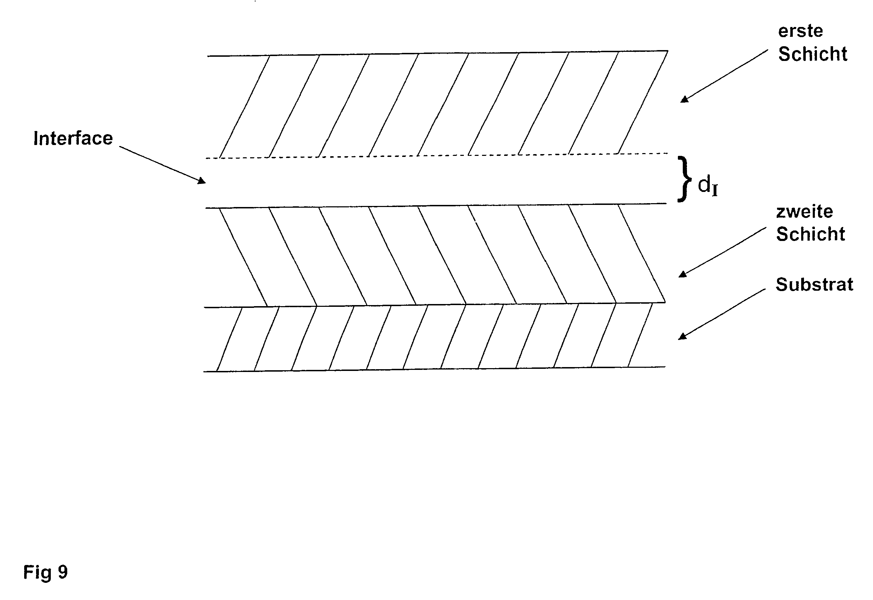

Bei der erfindungsgemäßen Herstellung von verlustarmen Multilayerschichten, bei der auf einer ersten Schicht mittels einer reaktiv betreibbaren Beschichtungseinrichtung eine Abscheidung einer zweiten Schicht mit mindestens einer Reaktivkomponente erfolgt, ist ebenfalls eine Änderung der Struktur und/oder Stöchiometrie der Schichten mittels einer Reaktionseinrichtung vorgesehen. Die erste Schicht kann auch Substrat sein. Eine schematische Darstellung einer Multilayerschicht auf einem Substrat mit einer ersten Schicht, einer zweiten Schicht und einem Interface der Dicke dₗ in einem an die erste Schicht angrenzenden Bereich der zweiten Schicht ist in Fig. 9 gezeigt. Als Beschichtungseinrichtung kann dabei jede reaktiv betreibbare Beschichtungseinrichtung eingesetzt werden, insbesondere Einrichtungen, die nach dem Prinzip des physical vapor deposition, wie etwa Aufdampf- oder Sputtertechniken arbeiten. Besonders bevorzugt sind DC- oder AC-Magnetronquellen. Als Reaktionseinrichtung ist eine Plasmaquelle, beispielsweise eine DC-, HF-, MF- oder DC-Puls oder DC- plus HF- oder Mikrowellenplasmaeinrichtung bevorzugt.

Bevorzugt sind Multilayerschichten aus abwechselnd hoch- und niederbrechenden Schichten, wie sie insbesondere für optische Filter eingesetzt werden. Die Multilayerschichten können auch aus alternierenden hoch-, nieder- und mittelbrechenden Schichten bestehen. Als hochbrechende Schicht wird eine Schicht mit einem Brechungsindex im Wesentlichen größer als 1,9, vorzugsweise zwischen 1,9 und 2,6, angesehen.

Als niederbrechend wird eine Schicht mit einem Brechungsindex zwischen 1,3 und 1,5 bezeichnet. Mittelbrechende Schichten haben ein Brechungsindex zwischen 1,5 und 1,9. Beispiele für hochbrechende Materialien in diesem Sinne sind beispielsweise Nb₂O₅, Ta₂O₅, TiO₂ oder ZrO₂. Niederbrechend sind beispielsweise Schichten aus SiO₂.

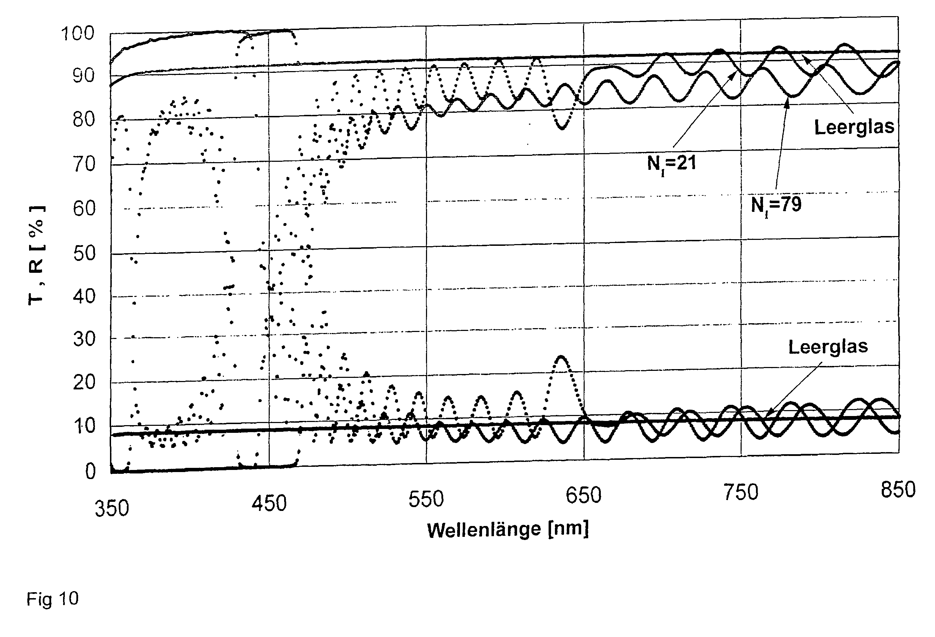

In Figur 10 sind Transmissions- bzw. Reflexionswerte mit einer Anzahl von Nₗ = 21 bzw. Nₗ = 79 Interfaces für Nb₂O₅ / SiO₂. Multilayerschichten in Abhängigkeit von der Wellenlänge dargestellt. Aus der Darstellung ist ersichtlich, dass mit wachsender Anzahl der Interfaces bzw. der Schichten der Multilayerschicht die optischen Verluste wachsen.

Die Abscheidung der Schichten sowie eine Änderung der Struktur und/oder Stöchiometrie der Schichten erfolgt bevorzugt durch das weiter oben beschriebene Verfahren, kann jedoch auch nach anderen Verfahren vorgenommen werden. Zur Verringerung eines optischen Verlustes der Multilayerschicht unter einem vorgegebenen Wert erfolgt in einem an die erste Schicht angrenzenden Bereich der zweiten Schicht, vorzugsweise mittels der Beschichtungseinrichtung ein Aufbau eines Interfaces mit einer Dicke dₗ und einem Wert eines Defizits der Reaktivkomponente DEF kleiner als ein Wert DEFₗ.

Erfindungsgemäß erfolgt ein Aufbau eines Interfaces mit einer Dicke dₗ und einem Wert eines Defizits der Reaktivkomponente DEF kleiner als DEFₗ, wobei die Multilayerschicht einen optischen Verlust aufweist, der einen vorgegebenen Mindestwert unterschreitet. Bevorzugt ist bei dem erfindungsgemäßen Verfahren, wenn die Dicke dₗ des Interfaces einen Mindestwert überschreitet. Der Rest der abgeschiedenen Schicht wird mit einem höheren Defizit DEF reaktiv abgeschieden.

Besonders bevorzugt wird das Interface durch Einwirkung der Reaktionseinrichtung mit möglichst vollständiger Stöchiometrie hergestellt.

Bevorzugt wird bei dem beschriebenen Verfahren eine niederbrechende Schicht aus SiO₂ auf einer hochbrechenden Schicht, beispielsweise Nb₂O₅, Ta₂O₅ oder dergleichen abgeschieden. Als Reaktivkomponente kann statt Sauerstoff auch Kohlenstoff oder Stickstoff verwendet werden. Auf der niederbrechenden Schicht kann wieder eine hochbrechende abgeschieden werden.

Beim erfindungsgemäßen Verfahren werden Werte einer momentanen Dicke d(t) der zweiten Schicht ermittelt und, sobald d(t) größer als ein Wert dₗ ist, wird die Abscheidung der zweiten Schicht mit einem Wert des Defizits der Reaktivkomponente DEF größer als DEFₗ vorgenommen. Dabei kann die Ermittlung der Werte der momentanen Dicke d(t) der zweiten Schicht während der Abscheidung der zweiten Schicht, beispielsweise in Abhängigkeit von einem Monitoring-Signal der optischen Monitoreinrichtung (8) erfolgen.

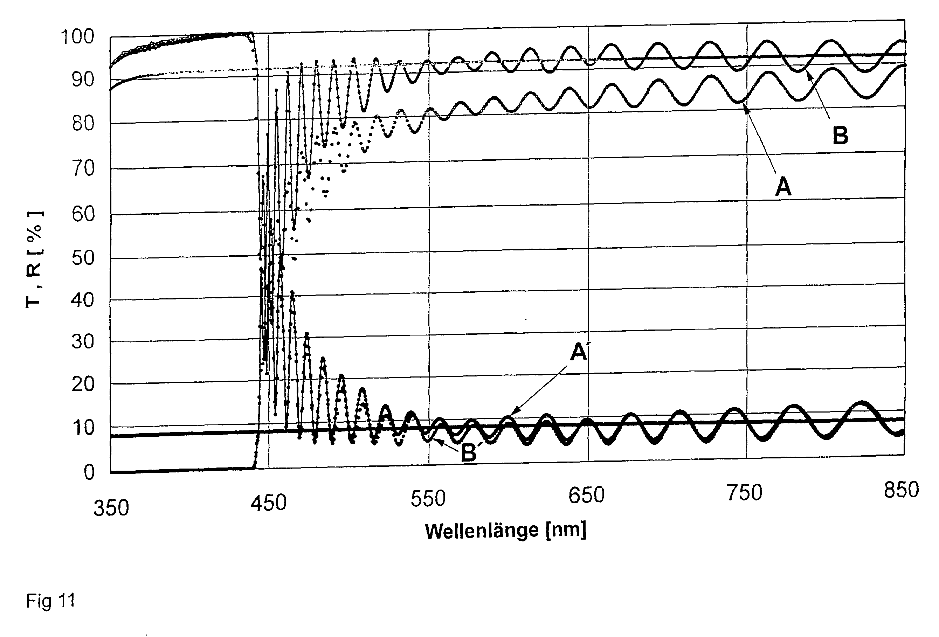

In Fig. 11 ist der Effekt einer Minimierung des optischen Verlustes für eine Multilayerschicht hergestellt nach dem erfindungsgemäßen Verfahren illustriert. Bei einer Nb₂O₅-/SiO₂-Multilayerschicht sind die Interfaces mit einem unterschiedlich hohen Defizit an Sauerstoff abgeschieden worden. Dabei bezeichnet A, A' die Werte von Reflektion bzw. Transmission in Abhängigkeit von der Wellenlänge für eine Multilayerschicht mit einem relativ großen Defizit an Sauerstoff am Interface, während B, B' die Werte von Transmission bzw. Reflektion für eine Multilayerschicht mit einem relativ geringen Sauerstoffdefizit an Interface bezeichnet. Die Kurven A, A' zeigen größere optische Verluste als die Kurven B, B'.

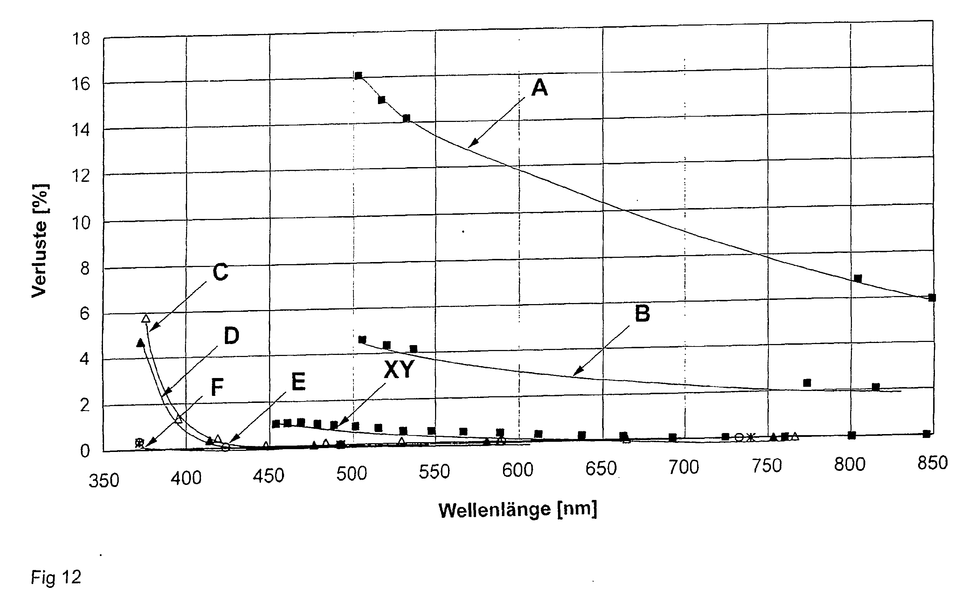

In Fig. 12 sind zur weiteren Illustrierung des erfindungsgemäßen Verfahrens für Einzelschichten aus hoch- bzw. niedrig brechendem Material und für Multilayerschichten mit abwechselnd hochbrechenden und niederbrechenden Schichten optische Verluste in Abhängigkeit von der Wellenlänge aufgetragen. Hier sind mit A die Werte einer Multilayerschicht mit 77 nicht optimierten Interfaces bezeichnet, während mit B Werte einer ansonsten gleichen Multilayerschicht mit 21 nicht optimierten Interfaces bezeichnet sind. Die Verluste von B sind geringer als von A, weil die Anzahl der Interfaces nur 21 gegenüber 77 beträgt. Die Werte einer Multilayerschicht vergleichbar mit A, jedoch mit optimierten Interfaces sind mit XY bezeichnet. Die Kurve XY zeigt dabei extrem reduzierte Verluste gegenüber der Kurve A für die entsprechend Multilayerschicht. Die Kurven C, D, E und F bezeichnen hoch- bzw. niedrig brechende Einzelschichten mit einer Dicke von 1.000 nm bzw. 500 nm.

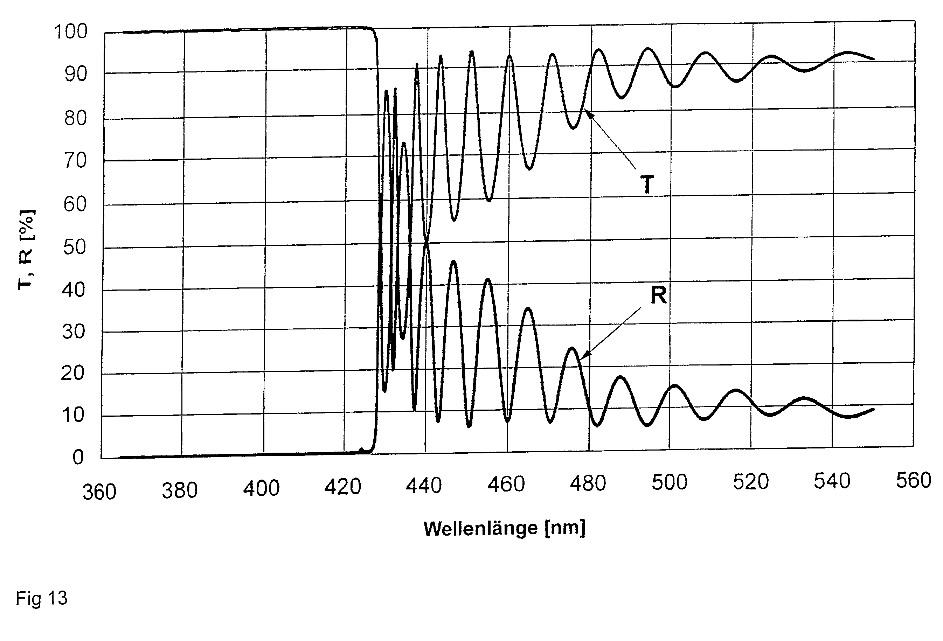

Fig. 13 zeigt Transmission und Reflektion in Abhängigkeit von der Wellenlänge für eine Nb₂O₅-/SiO₂-Multilayerschicht, die nach dem erfindungsgemäßen Verfahren zur Erreichung geringster optischer Verluste hergestellt ist. Misst man die Transmission und Reflektion eines Filters als Funktion der Wellenlänge, so hat das Filter Stellen maximaler und minimaler Transmission. An den Stellen max. Transmission ist die Reflektion minimal und umgekehrt. An diesen Stellen lassen sich die Verluste am einfachsten bestimmen: man subtrahiert von 100% Tmax und Rmin oder Tmin und Rmax. Eine Multilayerschicht gemäß Fig. 13 ist bevorzugt für Breitbandfilter vorgesehen.

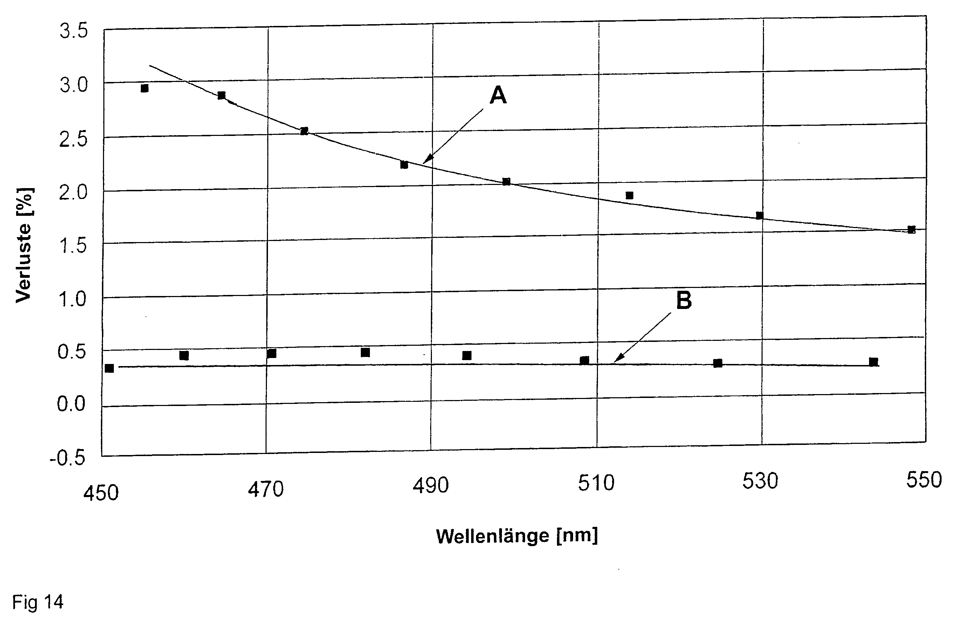

Fig. 14 illustriert für eine SiO₂-Interface-Schicht auf einer hochbrechenden Schicht den Effekt einer Variation der Dicke d der Interface-Schicht auf die optischen Verluste in Abhängigkeit von der Wellenlänge. Die mit A bezeichnete Kurve gibt Werte für eine 2,7 nm dicke Interface-Schicht, die eine deutliche Wellenlängenabhängigkeit zeigt. Im Vergleich dazu sind die Werte für eine 3,6 nm dicke Interface-Schicht mit B bezeichnet und zeigen erheblich geringere optische Verluste sowie eine weitgehende Unabhängigkeit von der Wellenlänge in dem dargestellten Bereich. Aus der Fig. 14 ist ferner ersichtlich, dass eine kritische Dicke der Interface-Schicht existiert, ab der es zu einer deutlichen Reduktion der optischen Verluste kommt, falls der Wert des Defizits der Reaktivkomponente DEF kleiner als ein kritischer Wert DEFₗ gewählt ist. Bei einer niederbrechenden Schicht SiO₂ auf einer hochbrechenden Schicht, beispielsweise Nb₂O₅, liegt der kritische Wert in einem Bereich zwischen 2,5 und 10,0 nm, vorzugsweise 2,6 nm, 2,7 nm ... 3,6 nm, 3,7 nm, 3,8 nm. Das Defizit DEF = 2 - x der Reaktivkomponente ist dabei relativ gering zu wählen, entsprechend einem Wert x der Reaktivkomponente von SiOx im Bereich des Interfaces von größer als 1,5, 1,6 ... bis 1,8.

In einer bevorzugten Ausführungsform des Verfahrens werden zur Herstellung der SiOx-Schicht im Interface-Bereich zunächst relativ dünne Schichten pro Rotation des Substrattellers bei relativ geringer Sputterleistung und einem relativ geringen Sauerstoffdefizit hergestellt. Bevorzugt wird im Übergangsbereich zum Oxidmode reaktiv gesputtert. Nach Erreichen einer vorgebbaren Schichtdicke, von beispielsweise 3,6 nm wird die SiOx-Schicht mit größerem Sauerstoffdefizit bei einer höheren Leistung abgeschieden und dem reaktiven Plasma der Plasmaquelle ausgesetzt. Dieses ist vorzugsweise konstant.

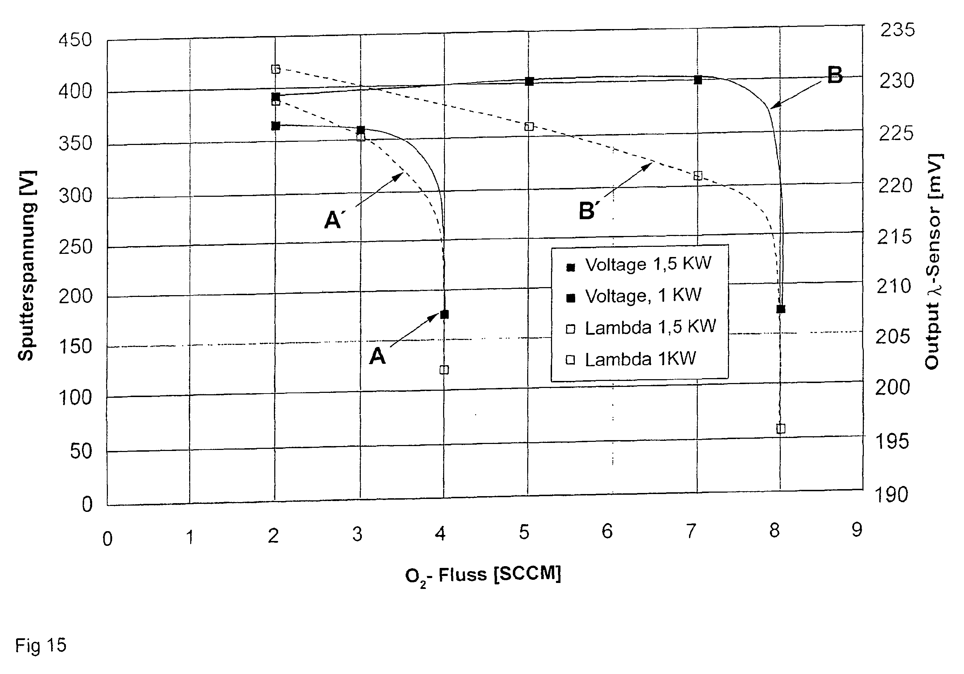

In Fig. 15 sind Kennlinien für die reaktive Abscheidung der Interface-Schicht mit geringem bzw. höheren Sauerstoffdefizit dargestellt. Mit A, A' sind Werte der Sputterspannung bzw. die Ausgangsleistung eines Lambda-Sensors bei 1 kW Sputterleistung und mit B und B' Werte der Sputterspannung und das Lambda-Signal bei einer Sputterleistung von 1,5 kW bezeichnet. Die Energie der schichtbildenden Teilchen liegt vorzugsweise zwischen einigen eV bis zu 200 eV. Bevorzugt ist, wenn die Teilchen des reaktiven Plasmas eine Energie von weniger als 50 eV haben.

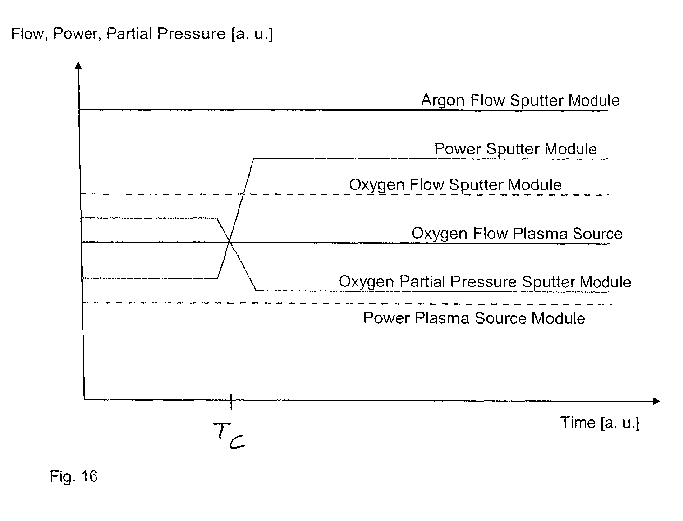

In Fig. 16 sind die zeitlichen Werteverläufe für wichtige Verfahrensparameter bei der reaktiven Kathodenzerstäubung mit Sauerstoff als reaktivem Bestandteil schematisch dargestellt, wie sie bei einer bevorzugten Ausführungsform des Verfahrens verwendet werden. Hierbei wird mit konstanten Werten der Plasmaquellenleistung, des Argonflusses im Bereich der Sputtereinrichtung sowie des Sauerstoffflusses im Bereich der Sputter- und der Plasmaquelle gearbeitet. Zu einem Zeitpunkt T_{C} wird die Leistung der Sputtereinrichtung erhöht. Ab diesem Zeitpunkt T_{C} ist der Sauerstoffpartialdruck im Bereich der Sputtereinrichtung reduziert. Bevorzugt ist zum Zeitpunkt T_{C} eine vorgegebene Schichtdicke von beispielsweise ca. 3 nm erreicht. Die bis zu diesem Zeitpunkt gesputterte Schicht weist ein relativ geringes Sauerstoffdefizit auf. Nach dem Zeitpunkt T_{C} gesputterte Schichten weisen dagegen ein relativ hohes Sauerstoffdefizit auf. Es versteht sich, dass sich in weiteren Ausführungsformen der Erfindung auch die Parameterwerte anderer Größen als die der Sputterleistung bzw. des Sauerstoffpartialdrucks im Bereich der Sputtereinrichtung zeitlich variieren können.

Durch die Abscheidung von relativ dünnen SiOx-Schichten mit einem relativ geringen Sauerstoffdefizit kann gewährleistet werden, dass sowohl die Interface-Schicht als auch die darunter liegende Schicht, beispielsweise aus Nb₂O₅, vermöge der auf die SiOx-Abscheidung folgenden Wirkung der reaktiven Plasmaquelle als stöchiometrische Schicht vorliegen. Insbesondere kann durch eine derartige Verfahrensweise erreicht werden, dass ein eventueller Entzug der Reaktivkomponente, insbesondere des Sauerstoffs, durch das reaktionsfreudige SiOx aus der darunter liegenden Schicht (Nb₂O₅) durch Einwirkung der Plasmaquelle kompensiert werden kann. Wird das SiOx dagegen mit einer zu hohen Rate abgeschieden, kann es durch reaktive Plasmaeinwirkung zwar noch zu einem stöchiometrischen SiO₂ oxidiert werden, wird dabei aber unter Umständen so dicht, dass ein ausreichender Durchgriff der Wirkung der Plasmaquelle zur Gewährleistung einer Stöchiometrie der darunter liegenden Schicht zu der unter der SiOx-Schicht liegenden Schicht nicht möglich ist. Ab einer bestimmten Dicke der mit einem geringen Sauerstoffdefizit aufgebrachten Interface-Schicht kann neu auf die bereits abgeschiedene Schicht aufgebrachtes SiOx der darunter liegenden Schicht keinen Sauerstoff mehr entziehen, so dass die weitere Abscheidung von SiOx mit einem höheren Defizit an Sauerstoff erfolgen kann.

## Patentansprüche

1. Verfahren zur Herstellung einer Multilayerschicht mit zumindest einer reaktiv betreibbaren Beschichtungseinrichtung (3) und zumindest einer Reaktionseinrichtung (5) in einer Vakuumkammer (10), wobei auf zumindest einem relativ zu der Beschichtungseinrichtung (3) oder der Reaktionseinrichtung (5) bewegbaren Substrat (2) auf einer ersten Schicht eine Abscheidung einer zweiten Schicht mit einer Reaktivkomponente erfolgt und eine Änderung der Struktur und/oder Stöchiometrie zumindest einer Schicht mittels der Reaktionseinrichtung (5) erfolgt, **dadurch gekennzeichnet, dass** zur Verringerung eines optischen Verlustes der Multilayerschicht unter einen vorgegebenen Wert in einem an die erste Schicht angrenzenden Bereich der zweiten Schicht ein Aufbau eines Interfaces mit einer Dicke dₗ und einem Wert eines Defizits der Reaktivkomponente DEF kleiner als ein Wert DEFₗ erfolgt und dass Werte einer momentanen Dicke d(t) der zweiten Schicht, vorzugsweise während der Abscheidung der zweiten Schicht, ermittelt werden und sobald d(t) größer als dₗ ist, die Abscheidung der zweiten Schicht mit einem Wert des Defizits der Reaktivkomponente DEF größer als DEFₗ erfolgt.

2. Verfahren nach Anspruch 1, **dadurch gekennzeichnet, dass** die erste Schicht hochbrechend und die zweite Schicht niederbrechend oder dass die erste Schicht niederbrechend und die zweite Schicht hochbrechend ausgebildet ist.

3. Verfahren nach Anspruch 2, **dadurch gekennzeichnet, dass** die hochbrechende Schicht aus Nb₂O₅, Ta₂O₅, TiO₂ oder ZrO₂, und die niederbrechende Schicht aus SiO₂.besteht.

4. Verfahren nach Anspruch 2 oder 3, **dadurch gekennzeichnet, dass** die hochbrechende Schicht Nb₂O5 und als niederbrechende Schicht Si02 vorgesehen ist und die Dicke dₗ der Interface-Schicht einen Wert in einem Bereich von 2,5 nm bis 10nm, vorzugsweise 2,6 nm, 2,7 nm oder 3,6 nm und das Defizit der Reaktivkomponente DEFₗ im Bereich des Interfaces einen Wert von kleiner als 0,5 aufweist.

5. Verfahren nach zumindest einem der vorhergehenden Ansprüche, **dadurch gekennzeichnet, dass** für eine gegebene Dicke dₗ des Interfaces mit einem zunehmenden Wert der Abscheidungsrate ein abnehmender Wert des Defizits der Reaktivkomponente DEF gewählt wird.

6. Verfahren nach zumindest einem der vorhergehenden Ansprüche, **dadurch gekennzeichnet, dass** die Multilayerschicht eine Anzahl von Interfaces zwischen hoch- und niederbrechenden Schichten Nₗ größer als 3, vorzugsweise größer als 20, besonders bevorzugt größer als 80 aufweist.

7. Verfahren nach zumindest einem der vorhergehenden Ansprüche, **dadurch gekennzeichnet, dass** die Beschichtungseinrichtung (3) ein vorzugsweise mit Mittelfrequenz betriebenes Magnetron-Quellensystem vorzugsweise mit zwei nebeneinander liegenden Magnetron-Anordnungen und/oder die Reaktiveinrichtung (5) eine vorzugsweise im RF-Bereich arbeitende Plasmaquelle ist.

8. Verfahren nach zumindest einem der vorhergehenden Ansprüche, **dadurch gekennzeichnet, dass** die Änderung der Struktur und/oder Stöchiometrie der Schichten jeweils nach Abscheidung einer Schicht mit einer vorgegebenen Schichtdicke erfolgt.

9. Verfahren, nach zumindest einem der vorhergehenden Ansprüche, **dadurch gekennzeichnet, dass** die Beschichtungseinrichtung eine Sputtereinrichtung (3, 7) und die Reaktionseinrichtung eine Plasmaquelle (5) ist und eine Schicht abgeschieden wird, wobei ein erster Konstituent der Schicht ein Sputtermaterial der Sputtereinrichtung (3, 7) und zumindest ein zweiter Konstituent eine Reaktivkomponente des Restgases der Vakuumkammer ist, wobei folgende Schritte vorgesehen sind:
- Unter Zuführung einer Reaktivkomponente reaktive Abscheidung zumindest einer Schicht mit einem vorgegebenen stöchiometrischen Defizit des zweiten konstituenten in einem räumlichen Bereich der Sputtereinrichtung (3, 7) auf dem Substrat (2),
- Bewegung des Substrats (2) mit der abgeschiedenen Schicht in einen räumlichen Bereich einer Plasmaquelle (5), die in einem vorgegebenen Abstand von der Sputtereinrichtung (3, 7) in der Vakuumkammer (10) angeordnet ist,
- Modifizierung der Struktur und/oder Stöchiometrie der Schicht durch Plasmaeinwirkung der Plasmaquelle (5), vorzugsweise unter Zuführung einer vorgegebenen Menge der Reaktivkomponente, zur Verringerung eines optischen Verlustes der Schicht (1).

10. Verfahren nach einem der Ansprüche 1 bis 8, **dadurch gekennzeichnet, dass** die Beschichtungseinrichtung eine Sputtereinrichtung (3, 7) und die Reaktionseinrichtung eine Plasmaquelle (5) ist und die Vakuumkammer ein Restgas aufweist und folgende Schritte vorgesehen sind:
- Unter Zuführung einer Reaktivkomponente, reaktive Abscheidung einer Schicht mit einer vorgegebenen Schichtdicke und einem optischen Verlust, der einen vorgegebenen Mindestwert unterschreitet, in einem räumlichen Bereich der Sputtereinrichtung (3, 7) auf dem Substrat (2),
- Bewegung des Substrats (2) mit der abgeschiedenen Schicht in einen räumlichen Bereich einer Plasmaquelle (5), die in einem vorgegebenen Abstand von der Sputtereinrichtung (3, 7) in der Vakuumkammer (10) angeordnet ist,
- Modifizierung der Struktur und/oder Stöchiometrie der Schicht durch Plasmaeinwirkung der Plasmaquelle (5), vorzugsweise unter Zuführung einer vorgegebenen Menge der Reaktivkomponente, zur Verringerung eines optischen Verlustes der Schicht (1),
- wobei ein erster Konstituent der Schicht ein Sputtermaterial der Sputtereinrichtung (3, 7) und zumindest ein zweiter Konstituent eine Reaktivkomponente des Restgases ist.

11. Verfahren nach Anspruch 10, **dadurch gekennzeichnet, dass** die Sputtereinrichtung (3, 7) in einem Sputtermaterial- und Reaktivgasmaterial-abhängigen Arbeitspunkt einer Kennlinie oder eines Kennfeldes betrieben wird.

12. Verfahren nach Anspruch 10 oder 11, **dadurch gekennzeichnet, dass** ein optisches Monitoring nach Abscheidung einer vorgegebenen Schichtdicke zur Einstellung von optischen Eigenschaften der Schicht vorgesehen ist.

13. Verfahren nach zumindest einem der Ansprüche 10 bis 12, **dadurch gekennzeichnet, dass** ein optisches Monitoring der Schicht nach Plasmaeinwirkung der Plasmaquelle (5) zur Einstellung von optischen Eigenschaften der Schicht vorgesehen ist.

14. Verfahren nach zumindest einem der Ansprüche 9 bis 13, **dadurch gekennzeichnet, dass** ein optisches Monitoring der Schicht nach Abscheidung einer vorgegebenen Schichtdicke und nach Plasmaeinwirkung der Plasmaquelle (5) zur Einstellung von optischen Eigenschaften der Schicht vorgesehen ist.

15. Verfahren nach zumindest einem der Ansprüche 12 bis 14, **dadurch gekennzeichnet, dass** als optisches Monitoring eine Ermittlung von Transmission, Reflektion und /oder Verlusten bei einer oder mehreren Wellenlängen der Schicht vorgesehen ist.

16. Verfahren nach zumindest einem der Ansprüche 9 bis 15, **dadurch gekennzeichnet, dass** in Abhängigkeit von einem Monitoring-Signal einer optischen Monitoreinrichtung (8) eine Regelung der Sputtereinrichtung (3, 7) erfolgt.

17. Verfahren nach zumindest einem der Ansprüche 9 bis 16, **dadurch gekennzeichnet, dass** in Abhängigkeit von einem Monitoring-Signal einer optischen Monitoreinrichtung (8) eine Regelung der Plasmaquelle (5) erfolgt.

18. Verfahren nach zumindest einem der Ansprüche 13 bis 17, **dadurch gekennzeichnet, dass** das optische Monitoring in Abhängigkeit von vorgegebenen Zeitpunkten und/oder von vorgegebenen Schichtdicken erfolgt.

19. Verfahren nach zumindest einem der Ansprüche 9 bis 18, **dadurch gekennzeichnet, dass** ein Partialdruck der Reaktivkomponente über einen Gasfluss der Reaktivkomponente und/oder über eine elektrische Leistung der Sputtereinrichtung (3, 7) geregelt wird.

20. Verfahren nach zumindest einem der vorhergehenden Ansprüche, **dadurch gekennzeichnet, dass** eine Sputterkathodenspannung der Sputtereinrichtung (3, 7) über einen Gasfluss der Reaktivkomponente geregelt wird.

21. Verfahren nach zumindest einem der vorhergehenden Ansprüche, **dadurch gekennzeichnet, dass** der Quotient einer Sputterrate zu einem Partialdruck einer Reaktivkomponente über eine Sputterleistung geregelt wird.

22. Verfahren nach Anspruch 21, **dadurch gekennzeichnet, dass** der Quotient aus dem Quotienten einer ersten Linienintensität und einer zweiten Linienintensität bestimmt wird, wobei die erste Linienintensität ein Maß für eine Sputterrate und die zweite Linienintensität für einen Partialdruck der Reaktivkomponente ist.

23. Verfahren nach zumindest einem der vorhergehenden Ansprüche 9-22, **dadurch gekennzeichnet, dass** die Reaktivkomponente Sauerstoff, Kohlenstoff und/oder Stickstoff ist.

24. Verfahren nach zumindest einem der Ansprüche 9 bis 23, **dadurch gekennzeichnet, dass** Partialdrücke der Reaktivkomponente im Bereich der Sputtereinrichtung (3, 7) und im Bereich der Plasmaquelle (5) im wesentlichen unabhängig voneinander eingestellt werden.

25. Verfahren nach zumindest einem der vorhergehenden Ansprüche 9-24, **dadurch gekennzeichnet, dass** eine Plasmaeinwirkung mit einem Plasma einer Plasmaquelle (5) erfolgt, welches zumindest die Reaktivkomponente im Plasma enthält.

26. Verfahren nach zumindest einem der Ansprüche 9 bis 25, **dadurch gekennzeichnet, dass** das Substrat (2) mit einer vorgegebenen Geschwindigkeit an der Plasmaquelle (5) und/oder der Sputtereinrichtung (3, 7) vorbeigeführt wird.

27. Verfahren nach zumindest einem der Ansprüche 9 bis 26, **dadurch gekennzeichnet, dass** das Substrat (2) an der Plasmaquelle (5) und/oder der Sputtereinrichtung (3, 7) mit einer variablen Geschwindigkeit vorbei bewegt wird.

28. Verfahren nach zumindest einem der vorhergehenden Ansprüche 9-27, **dadurch gekennzeichnet, dass** das Substrat (2) mehrfach an der Sputtereinrichtung (3, 7) und/oder an der Plasmaquelle (5) vorbei bewegt wird.

29. Verfahren nach zumindest einem der vorhergehenden Ansprüche 9-28, **dadurch gekennzeichnet, dass** ein Gasfluss der Reaktivkomponente in Abhängigkeit von optischen Eigenschaften der Schicht gesteuert oder geregelt wird.

30. Verfahren nach zumindest einem der vorhergehenden Ansprüche 9-29, **dadurch gekennzeichnet, dass** das Substrat (2) vor, während oder nach der Modifizierung mit Wärme beaufschlagt wird, vorzugsweise mittels einer Strahlungsheizung.

31. Verfahren nach zumindest einem der Ansprüche 9 bis 30, **dadurch gekennzeichnet, dass** ein Gasfluss der Reaktivkomponente in Abhängigkeit von einer abgeschiedenen Schichtdicke und/oder einer Zeitdauer der Modifizierung und/oder einer Anzahl der Vorbeiführungen an der Plasmaquelle (5) gesteuert oder geregelt wird.

32. Verfahren nach zumindest einem der vorhergehenden Ansprüche 9 bis 31, **dadurch gekennzeichnet, dass** als Sputtereinrichtung (3, 7) eine, vorzugsweise magnetronunterstützte Kathodenzerstäubungsquelle vorgesehen ist.

33. Verfahren nach zumindest einem der vorhergehenden Ansprüche 9-32, **dadurch gekennzeichnet, dass** die Sputtereinrichtung (3, 7) mit einem elektrischen Wechselfeld betrieben wird.

34. Verfahren zur Herstellung eines Breitbandfilters, **dadurch gekennzeichnet, dass** eine nach einem Verfahren gemäß einem der vorhergehenden Ansprüche hergestellte Schicht aus Nb₂O₅/SiO₂ verwendet wird.

35. Vorrichtung zur Herstellung einer Multilayerschicht mit zumindest einer reaktiv betreibbaren Beschichtungseinrichtung (3), insbesondere einer Sputtereinrichtung und zumindest einer Reaktionseinrichtung (5), insbesondere einer Plasmaquelle in einer Vakuumkammer (10), wobei auf zumindest einem relativ zu der Beschichtungseinrichtung (3) und der Reaktionseinrichtung (5) bewegbaren Substrat auf einer ersten Schicht eine Abscheidung einer zweiten Schicht mit mindestens einer Reaktivkomponente erfolgen kann und eine Änderung der Struktur und/oder Stöchiometrie zumindest einer Schicht mittels der Reaktionseinrichtung (5) erfolgt, **dadurch gekennzeichnet, dass** zur Verringerung eines optischen Verlustes der Multilayerschicht unter einem vorgegebenen Wert eine Steuereinrichtung zur Steuerung der Beschichtungs- und Reaktionseinrichtung vorgesehen ist, die ausgelegt ist um mittels der in einem an die erste Schicht angrenzenden Bereich der zweiten Schicht ein Interface mit einer Dicke dₗ und einem Wert eines Defizits der Reaktivkomponente DEF kleiner als ein Wert DEFₗ aufzubauen, wobei ein optischer Monitor vorgesehen ist, um Werte einer momentanen Dicke d(t) der zweiten Schicht, vorzugsweise während der Abscheidung der zweiten Schicht, zu ermitteln, wobei sobald d(t) größer als dₗ ist, die Abscheidung der zweiten Schicht mit einem Wert des Defizits der Reaktivkomponente DEF größer als DEFₗ erfolgt.

## Claims

1. Method for producing a multilayer coating with at least one reactively operable coating device (3) and at least one reaction device (5) in a vacuum chamber (10), wherein a second coating with a reactive component is deposited on a first coating on at least one substrate (2) which is moveable relative to the coating device (3) or to the reaction device (5) and a change of the structure and/or stoichiometry of at least one coating is effected by means of the reaction device (5), **characterized in that** an interface is constructed with a thickness dₗ and a value of a deficit of the reactive component DEF which is less than a value DEFₗ in order to reduce an optical loss of the multilayer coating under a prespecified value in a region of the second coating which adjoins the first coating, and **in that** values of an instantaneous thickness d(t) of the second coating are ascertained, preferably during the deposition of the second coating, and, as soon as d(t) is greater than dₗ, the second coating with a value of the deficit of the reactive component DEF which is greater than DEFₗ is deposited.

2. Method according to Claim 1, **characterized in that** the first coating is of high refractive index and the second coating is of low refractive index or **in that** the first coating is of low refractive index and the second coating is of high refractive index.

3. Method according to Claim 2, **characterized in that** the high refractive index coating is made of Nb₂O₅, Ta₂O₅, TiO₂ or ZrO₂ and the low refractive index coating is made of SiO₂.

4. Method according to Claim 2 or 3, **characterized in that** the high refractive index coating Nb₂O₅ and SiO₂ as the low refractive index coating are provided and the thickness dₗ of the interface coating has a value in a range from 2.5 nm to 10 nm, preferably 2.6 nm, 2.7 nm or 3.6 nm, and the deficit of the reactive component DEFₗ in the range of the interface has a value of less than 0.5.

5. Method according to at least one of the preceding claims, **characterized in that**, as the value of the deposition rate increases, a decreasing value of the deficit of the reactive component DEF is chosen for a given thickness dₗ of the interface.

6. Method according to at least one of the preceding claims, **characterized in that** the multilayer coating has a number of interfaces between high refractive index coatings and low refractive index coatings Nₗ of greater than 3, preferably greater than 20, particularly preferably greater than 80.

7. Method according to at least one of the preceding claims, **characterized in that** the coating device (3) is a magnetron source system preferably operated at medium frequency, preferably with two magnetron arrangements located next to each other and/or the reactive device (5) is a plasma source which preferably operates in the RF range.

8. Method according to at least one of the preceding claims, **characterized in that** the change of the structure and/or stoichiometry of the coatings is effected in each case after deposition of a coating with a prespecified coating thickness.

9. Method according to at least one of the preceding claims, **characterized in that** the coating device is a sputtering device (3, 7) and the reaction device is a plasma source (5) and a coating is deposited, wherein a first constituent of the coating is a sputtering material of the sputtering device (3, 7) and at least one second constituent is a reactive component of the residual gas in the vacuum chamber, wherein the following steps are provided:
- reactive deposition of at least one coating with a prespecified stoichiometric deficit of the second constituent in a spatial region of the sputtering device (3, 7) on the substrate (2) while simultaneously feeding in a reactive component,
- movement of the substrate (2) with the deposited coating into a spatial region of a plasma source (5) which is arranged in the vacuum chamber (10) at a prespecified spacing from the sputtering device (3, 7),
- modification of the structure and/or stoichiometry of the coating by way of plasma action of the plasma source (5), preferably while simultaneously feeding in a prespecified quantity of the reactive component, in order to reduce an optical loss of the coating (1).

10. Method according to one of Claims 1 to 8, **characterized in that** the coating device is a sputtering device (3, 7) and the reaction device is a plasma source (5) and the vacuum chamber has a residual gas and the following steps are provided:
- reactive deposition of a coating with a prespecified coating thickness and an optical loss, which is below a prespecified minimum value, in a spatial region of the sputtering device (3, 7) on the substrate (2) while simultaneously feeding in a reactive component,
- movement of the substrate (2) with the deposited coating into a spatial region of a plasma source (5) which is arranged in the vacuum chamber (10) at a prespecified spacing from the sputtering device (3, 7),
- modification of the structure and/or stoichiometry of the coating by way of plasma action of the plasma source (5), preferably while simultaneously feeding in a prespecified quantity of the reactive component, in order to reduce an optical loss of the coating (1),
- wherein a first constituent of the coating is a sputtering material of the sputtering device (3, 7) and at least one second constituent is a reactive component of the residual gas.

11. Method according to Claim 10, **characterized in that** the sputtering device (3, 7) is operated in a sputtering material- and reactive gas material-dependent working point of a characteristic or a family of characteristics.

12. Method according to Claim 10 or 11, **characterized in that** optical monitoring is provided after deposition of a prespecified coating thickness in order to set optical properties of the coating.

13. Method according to at least one of Claims 10 to 12, **characterized in that** optical monitoring of the coating is provided after the plasma action of the plasma source (5) in order to set optical properties of the coating.

14. Method according to at least one of Claims 9 to 13, **characterized in that** optical monitoring of the coating is provided after deposition of a prespecified coating thickness and after the plasma action of the plasma source (5) in order to set optical properties of the coating.

15. Method according to at least one of Claims 12 to 14, **characterized in that** an ascertainment of transmission, reflection and/or losses at one or more wavelengths of the coating is provided as optical monitoring.

16. Method according to at least one of Claims 9 to 15, **characterized in that** the sputtering device (3, 7) is regulated as a function of a monitoring signal of an optical monitor device (8).

17. Method according to at least one of Claims 9 to 16, **characterized in that** the plasma source (5) is regulated as a function of a monitoring signal of an optical monitor device (8).

18. Method according to at least one of Claims 13 to 17, **characterized in that** optical monitoring is effected as a function of prespecified points in time and/or of prespecified coating thicknesses.

19. Method according to at least one of Claims 9 to 18, **characterized in that** a partial pressure of the reactive component is regulated via a gas flow of the reactive component and/or via an electrical power of the sputtering device (3, 7).

20. Method according to at least one of the preceding claims, **characterized in that** a sputtering cathode voltage of the sputtering device (3, 7) is regulated via a gas flow of the reactive component.

21. Method according to at least one of the preceding claims, **characterized in that** the quotient of a sputtering rate to a partial pressure of a reactive component is regulated via a sputtering power.

22. Method according to Claim 21, **characterized in that** the quotient is determined from the quotient of a first line intensity and a second line intensity, wherein the first line intensity is a measure of a sputtering rate and the second line intensity is a measure of a partial pressure of the reactive component.

23. Method according to at least one of the preceding Claims 9 to 22, **characterized in that** the reactive component is oxygen, carbon and/or nitrogen.

24. Method according to at least one of Claims 9 to 23, **characterized in that** partial pressures of the reactive component in the region of the sputtering device (3, 7) and in the region of the plasma source (5) are set in a manner substantially independent of one another.

25. Method according to at least one of the preceding Claims 9 to 24, **characterized in that** a plasma action is effected with plasma of a plasma source (5), which plasma contains at least the reactive component in the plasma.

26. Method according to at least one of Claims 9 to 25, **characterized in that** the substrate (2) is guided past the plasma source (5) and/or the sputtering device (3, 7) at a prespecified speed.

27. Method according to at least one of Claims 9 to 26, **characterized in that** the substrate (2) is moved past the plasma source (5) and/or the sputtering device (3, 7) at a variable speed.

28. Method according to at least one of the preceding Claims 9 to 27, **characterized in that** the substrate (2) is repeatedly moved past the sputtering device (3, 7) and/or the plasma source (5).

29. Method according to at least one of the preceding Claims 9 to 28, **characterized in that** a gas flow of the reactive component is controlled or regulated as a function of optical properties of the coating.

30. Method according to at least one of the preceding Claims 9 to 29, **characterized in that** heat is applied to the substrate (2) before, during or after the modification, preferably by means of a radiant heating system.

31. Method according to at least one of Claims 9 to 30, **characterized in that** a gas flow of the reactive component is controlled or regulated as a function of a deposited coating thickness and/or a period of modification and/or a number of passages past the plasma source (5).

32. Method according to at least one of the preceding Claims 9 to 31, **characterized in that** a, preferably magnetron-assisted, cathode sputtering source is provided.

33. Method according to at least one of the preceding Claims 9 to 32, **characterized in that** the sputtering device (3, 7) is operated using an alternating electrical field.

34. Method for producing a broadband filter, **characterized in that** a coating, produced according to a method as per one of the preceding claims, made of Nb₂O₅/SiO₂ is used.

35. Device for producing a multilayer coating with at least one reactively operable coating device (3), in particular a sputtering device, and at least one reaction device (5), in particular a plasma source, in a vacuum chamber (10), wherein a second coating with at least one reactive component can be deposited on a first coating on at least one substrate which is moveable relative to the coating device (3) and to the reaction device (5) and a change of the structure and/or stoichiometry of at least one coating is effected by means of the reaction device (5), **characterized in that** a control device for controlling the coating and reaction device is provided in order to reduce an optical loss of the multilayer coating under a prespecified value, which control device is configured to construct, in a region of the second coating which adjoins the first coating, an interface with a thickness dₗ and a value of a deficit of the reactive component DEF which is less than a value DEFₗ, wherein an optical monitor is provided for ascertaining values of an instantaneous thickness d(t) of the second coating, preferably during the deposition of the second coating, wherein, as soon as d(t) is greater than dₗ, the second coating with a value of the deficit of the reactive component DEF which is greater than DEFₗ is deposited.

## Revendications

1. Procédé de fabrication d'une couche stratifiée qui présente au moins un dispositif de revêtement (3) apte à fonctionner en conditions réactives et au moins un dispositif de réaction (5) dans une chambre sous vide (10), dans lequel une deuxième couche dotée d'un composant réactif est déposée sur une première couche d'au moins un substrat (2) apte à être déplacé par rapport au dispositif de revêtement (3) ou au dispositif de réaction (5) et dans lequel la structure et/ou la stoechiométrie d'au moins une couche sont modifiées au moyen du dispositif de réaction (5), **caractérisé en ce que**
pour abaisser la perte optique de la couche stratifiée en dessous d'une valeur prédéterminée dans une partie de la deuxième couche adjacente à la première couche, une interface d'une épaisseur d₁ et dont la valeur du déficit en composant réactif DEF est inférieure à une valeur DEF₁ est formée et
**en ce que** les valeurs de l'épaisseur instantanée d(t) de la deuxième couche sont déterminées de préférence pendant le dépôt de la deuxième couche, et dès que d(t) est supérieur à d₁, la deuxième couche est déposée à une valeur du déficit en composant réactif DEF supérieure à DEF₁.

2. Procédé selon la revendication 1, **caractérisé en ce que** la première couche a un haut indice de réfraction et la deuxième couche un bas indice de réfraction ou **en ce que** la première couche a un bas indice de réfraction et la deuxième couche un haut indice de réfraction.

3. Procédé selon la revendication 2, **caractérisé en ce que** la couche à haut indice de r**é**fraction est constituée de Nb₂O₅, de Ta₂O₅, de TiO₂ ou de ZrO₂ et la couche à bas indice de réfraction de SiO₂.

4. Procédé selon les revendications 2 ou 3, **caractérisé en ce que** du Nb₂O₅ est prévu pour la couche à haut indice de réfraction et du SiO₂ pour la couche à bas indice de réfraction, **en ce que** l'épaisseur d₁ de la couche d'interface a une valeur comprise entre 2,5 nm et 10 nm et est de préférence de 2,6 nm, de 2,7 nm ou de 3,6 nm et **en ce que** le déficit en composant réactif DEF₁ a une valeur inférieure à 0,5 dans la zone occupée par l'interface.

5. Procédé selon au moins l'une des revendications précédentes, **caractérisé en ce que** pour une épaisseur d₁ donnée de l'interface, on sélectionne une valeur décroissante du déficit du composant réactif DEF lorsque la valeur du taux de dépôt augmente.

6. Procédé selon au moins l'une des revendications précédentes, **caractérisé en ce que** la couche stratifiée présente entre les couches à haut indice de réfraction et les couches à bas indice de réfraction supérieur un nombre N₁ d'interfaces à 3, de préférence supérieur à 20 et de façon particulièrement préférable supérieur à 80.

7. Procédé selon au moins l'une des revendications précédentes, **caractérisé en ce que** le dispositif de revêtement (3) est un système à source magnétron travaillant de préférence à fréquence moyenne, de préférence doté de deux systèmes à magnétron situés l'un à côté de l'autre, et/ou **en ce que** le dispositif de réaction (5) est une source plasma qui travaille de préférence dans la plage RF des fréquences radio.

8. Procédé selon au moins l'une des revendications précédentes, **caractérisé en ce que** la structure et/ou la stoechiométrie de chaque couche sont modifiées après le dépôt d'une couche à une épaisseur prédéterminée.

9. Procédé selon au moins l'une des revendications précédentes, **caractérisé en ce que** le dispositif de revêtement est un dispositif de pulvérisation (3, 7) et le dispositif de réaction une source plasma (5), **en ce que** l'on dépose une couche dont un premier constituant est un matériau de pulvérisation du dispositif de pulvérisation (3, 7) et dont au moins un deuxième constituant est un composant réactif du gaz résiduel de la chambre sous vide, les étapes suivantes étant prévues :
- par apport d'un composant réactif, on dépose en conditions réactives sur le substrat (2) au moins une couche dont le déficit stoechiométrique en le deuxième constituant est prédéterminé dans une partie de l'espace du dispositif de pulvérisation (3, 7),
- le substrat (2) sur lequel la couche a été déposée est déplacé dans une partie de l'espace d'une source de plasma (5) disposée dans la chambre sous vide (10) à distance prédéterminée du dispositif de pulvérisation (3, 7),
- la structure et/ou la stoechiométrie de la couche sont modifiées par action du plasma de la source de plasma (5), de préférence en apportant une quantité prédéterminée du composant réactif, pour diminuer la perte optique de la couche (1).

10. Procédé selon l'une des revendications 1 à 8, **caractérisé en ce que** le dispositif de revêtement est un dispositif de pulvérisation (3, 7) et le dispositif de réaction une source plasma (5), la chambre sous vide présentant un gaz résiduel, et dans lequel les étapes suivantes sont prévues :
- par apport d'un composant réactif, on dépose en conditions réactives sur le substrat (2) et dans une partie de l'espace du dispositif de pulvérisation (3, 7) une couche d'épaisseur prédéterminée dont la perte optique est inférieure à une valeur minimale prédéterminée,
- le substrat (2) sur lequel la couche a été déposée est déplacé dans une partie de l'espace d'une source de plasma (5) disposée dans la chambre sous vide (10) à une distance prédéterminée du dispositif de pulvérisation (3, 7),
- la structure et/ou la stoechiométrie de la couche sont modifiées par action du plasma de la source de plasma (5), de préférence en apportant une quantité prédéterminée du composant réactif, pour diminuer la perte optique de la couche (1),
- un premier constituant de la couche étant un matériau de pulvérisation du dispositif de pulvérisation (3, 7) et au moins un deuxième constituant étant un composant réactif du gaz résiduel.

11. Procédé selon la revendication 10, **caractérisé en ce que** le dispositif de pulvérisation (3, 7) travaille à un point de travail situé sur une ligne caractéristique ou dans un champ de lignes caractéristiques, le point de travail dépendant du matériau de pulvérisation et du matériau gazeux réactif.

12. Procédé selon les revendications 10 ou 11, **caractérisé en ce que** pour ajuster les propriétés optiques de la couche, une surveillance optique est prévue après le dépôt d'une couche d'épaisseur prédéterminée.

13. Procédé selon au moins l'une des revendications 10 à 12 **caractérisé en ce que** pour ajuster les propriétés optiques de la couche, une surveillance optique de la couche est prévue après l'action du plasma de la source de plasma (5).

14. Procédé selon au moins l'une des revendications 9 à 13, **caractérisé en ce que** pour ajuster les propriétés optiques de la couche, une surveillance optique de la couche est prévue après le dépôt d'une couche d'épaisseur prédéterminée et après l'action du plasma de la source de plasma (5).

15. Procédé selon au moins l'une des revendications 12 à 14, **caractérisé en ce que** comme surveillance optique, il prévoit la détermination de la transmission, de la réflexion et/ou des pertes de la couche à une ou plusieurs longueurs d'onde.

16. Procédé selon au moins l'une des revendications 9 à 15, **caractérisé en ce qu'**un dispositif (8) de surveillance optique assure la régulation du dispositif de pulvérisation (3, 7) en fonction d'un signal de surveillance.

17. Procédé selon au moins l'une des revendications 9 à 16, **caractérisé en ce qu'**un dispositif (8) de surveillance optique assure la régulation de la source de plasma (5) en fonction d'un signal de surveillance.

18. Procédé selon au moins l'une des revendications 13 à 17, **caractérisé en ce que** la surveillance optique s'effectue à des instants prédéterminés et/ou à des épaisseurs de couche prédéterminées.

19. Procédé selon au moins l'une des revendications 9 à 18, **caractérisé en ce que** l'on régule la pression partielle du composant réactif par l'intermédiaire de l'écoulement de gaz du composant réactif et/ou de la puissance électrique du dispositif de pulvérisation (3, 7).

20. Procédé selon au moins l'une des revendications précédentes, **caractérisé en ce que** l'on régule la tension de la cathode de pulvérisation du dispositif de pulvérisation (3, 7) par l'intermédiaire de l'écoulement de gaz du composant réactif.

21. Procédé selon au moins l'une des revendications précédentes, **caractérisé en ce que** l'on régule le quotient entre le taux de pulvérisation et la pression partielle d'un composant réactif par l'intermédiaire de la puissance de pulvérisation.

22. Procédé selon la revendication 21, **caractérisé en ce que** l'on détermine le quotient à partir du quotient de l'intensité d'une première ligne et de l'intensité d'une deuxième ligne, l'intensité de la première ligne étant une mesure du taux de pulvérisation et l'intensité de la deuxième ligne une mesure de la pression partielle du composant réactif.

23. Procédé selon au moins l'une des revendications 9 à 22 qui précèdent, **caractérisé en ce que** le composant réactif est l'oxygène, le carbone et/ou l'azote.

24. Procédé selon au moins l'une des revendications 9 à 23, **caractérisé en ce que** les pressions partielles du composant réactif dans la zone occupée par le dispositif de pulvérisation (3, 7) et dans la zone occupée par la source de plasma (5) sont réglées d'une manière essentiellement indépendante l'une de l'autre.

25. Procédé selon au moins l'une des revendications 9 à 24 qui précèdent, **caractérisé en ce que** l'action du plasma s'effectue avec le plasma d'une source de plasma (5), lequel plasma contenant au moins le composant réactif.

26. Procédé selon au moins l'une des revendications 9 à 25, **caractérisé en ce que** le substrat (2) est déplacé à une vitesse prédéterminée devant la source de plasma (5) et/ou le dispositif de pulvérisation (3, 7).

27. Procédé selon au moins l'une des revendications 9 à 26, **caractérisé en ce que** le substrat (2) est déplacé à une vitesse variable devant la source de plasma (5) et/ou devant le dispositif de pulvérisation (3, 7).

28. Procédé selon au moins l'une des revendications 9 à 27 qui précèdent, **caractérisé en ce que** le substrat (2) est déplacé plusieurs fois devant le dispositif de pulvérisation (3, 7) et/ou devant la source de plasma (5).

29. Procédé selon au moins l'une des revendications 9 à 28 qui précèdent, **caractérisé en ce que** l'écoulement de gaz du composant réactif est commandé ou régulé en fonction des propriétés optiques de la couche.

30. Procédé selon au moins l'une des revendications 9 à 29 qui précèdent, **caractérisé en ce qu'**avant ou après sa modification, de la chaleur est appliquée sur le substrat (2), de préférence au moyen d'un chauffage radiant.

31. Procédé selon au moins l'une des revendications 9 à 30, **caractérisé en ce que** l'écoulement de gaz du composant réactif est commandé ou régulé en fonction de l'épaisseur de la couche déposée et/ou de la durée de la modification et/ou du nombre de passages devant la source de plasma (5).

32. Procédé selon au moins l'une des revendications 9 à 31 qui précèdent, **caractérisé en ce que** comme dispositif de pulvérisation (3, 7), il prévoit une source de pulvérisation cathodique, de préférence soutenue par magnétron.

33. Procédé selon au moins l'une des revendications 9 à 32 qui précèdent, **caractérisé en ce que** le dispositif de pulvérisation (3, 7) fonctionne avec un champ électrique à alternatif.

34. Procédé de fabrication d'un filtre à large bande, **caractérisé en ce qu'**il utilise une couche de Nb₂O₅/SiO₂ réalisée en appliquant un procédé selon l'une des revendications précédentes.

35. Dispositif de fabrication d'une couche stratifiée, lequel dispositif présente dans une chambre sous vide (10) au moins un dispositif de revêtement (3) qui peut fonctionner en conditions réactives, en particulier un dispositif de pulvérisation, et au moins un dispositif de réaction (5), en particulier une source de plasma, une deuxième couche qui comprend au moins un composant réactif pouvant être déposée sur une première couche d'au moins un substrat apte à être déplacé par rapport au dispositif de revêtement (3) et au dispositif de réaction (5), la structure et/ou la stoechiométrie d'au moins une couche étant modifiées au moyen du dispositif de réaction (5),
**caractérisé en ce que**
pour abaisser la perte optique de la couche stratifiée en dessous d'une valeur prédéterminée, un dispositif de commande est prévu pour commander le dispositif de revêtement et le dispositif de réaction et est conçu pour établir au moyen de ces derniers, dans une partie de la deuxième couche adjacente à la première couche, une interface d'épaisseur d₁ dont la valeur du déficit en composant réactif DEF est inférieure à une valeur DEF₁,
**en ce qu'**un dispositif de surveillance optique est prévu pour déterminer les valeurs instantanées de l'épaisseur d(t) de la deuxième couche, de préférence pendant le dépôt de la deuxième couche, de telle sorte que dès que d(t) est supérieur à d₁, le dépôt de la deuxième couche a lieu à une valeur du déficit en composant réactif DEF supérieure à DEF₁.
